# EUROPEAN PATENT SPECIFICATION

(11) **EP 1 640 805 B1**
(45) Date of publication and mention of the grant of the patent: **22.08.2007**
(21) Application number: 05020667.1
(22) Date of filing: 22.09.2005
(51) Int. Cl.: G03F 7/11, B41C 1/10, B41M 5/36

(54) **Lithographic printing plate precursor**
Flachdruckplattenvorläufer
Précurseur de plaque d'impression planographique

(30) Priority: 24.09.2004 JP 2004278182
(43) Date of publication of application: 29.03.2006
(73) Proprietor: FUJIFILM Corporation, Minato-ku Tokyo (JP)
(72) Inventor: Mori, Takanori, Yoshida-cho, Haibara-gun, Shizuoka (JP); Goto, Takahiro, Yoshida-cho, Haibara-gun, Shizuoka (JP)
(74) Representative: HOFFMANN EITLE

(56) References cited:
- EP-A- 1 518 672
- PATENT ABSTRACTS OF JAPAN vol. 1999, no. 05, 31 May 1999 (1999-05-31) & JP 11 038633 A (FUJI PHOTO FILM CO LTD), 12 February 1999 (1999-02-12)
- PATENT ABSTRACTS OF JAPAN vol. 1999, no. 05, 31 May 1999 (1999-05-31) & JP 11 038645 A (FUJI PHOTO FILM CO LTD), 12 February 1999 (1999-02-12)

## Description

### FIELD OF THE INVENTION

The present invention relates to a negative-working lithographic printing plate precursor capable of conducting direct drawing with a laser beam and rapid processing, and more particularly to a lithographic printing plate precursor wherein adhesion resistance of a back layer side thereof to a photosensitive layer side thereof is improved.

### BACKGROUND OF THE INVENTION

As lithographic printing plate precursors, PS plates comprising a hydrophilic support having provided thereon a lipophilic photosensitive resin layer have hitherto been widely used. As for the plate-making method thereof, the PS plate is ordinarily subjected to mask exposure (open-frame-exposure) via a lith film and then dissolution and removal of the non-image area to obtain a desired printing plate. Digitized techniques of electronically processing, accumulating and outputting image data using a computer have prevailed in recent years, and various image output systems corresponding to the digitized techniques have been put into practical use. As a result, a computer-to-plate (CTP) technique of directly making a printing plate by scanning digitized image data with highly convergent light, for example, a laser beam without using a lith film is eagerly desired. With such a tendency, it has become an important technical subject to obtain a printing plate precursor well adapted to such a purpose.

As such a lithographic printing plate precursor capable of being subjected to scanning exposure, a lithographic printing plate precursor having a constitution comprising a hydrophilic support having provided thereon a lipophilic photosensitive resin layer (hereinafter sometimes referred to as a "photosensitive layer") containing a photosensitive compound capable of generating an active species, for example, a radical or a Bronsted acid, by laser exposure has been proposed and printing plate precursors of such kinds have been on the market. A negative-working lithographic printing plate can be obtained by scanning exposing the lithographic printing plate precursor with a laser beam on the basis of digital data to generate an active species, causing physical or chemical change in the photosensitive layer by the action of the active species to make the photosensitive layer insoluble, and then conducting development processing of the lithographic printing plate precursor. In particular, a lithographic printing plate precursor comprising a hydrophilic support having provided thereon a polymerization type photosensitive layer containing a polymerization initiator having excellent photo speed, an addition polymerizable ethylenically unsaturated compound and a binder polymer soluble in an alkali developer, and, if desired, an oxygen-shielding protective layer is excellent in productivity, easy to perform development processing, and able to provide a printing plate having desired printing properties, for example, excellent resolving power and ink receptivity. In order to accelerate a hardening reaction of the photosensitive layer, there are heretofore known a method of providing a protective layer containing a water-soluble polymer on the photosensitive layer and a method of providing a protective layer containing an inorganic stratiform compound and a water-soluble polymer on the photosensitive layer (see, for example, JP-A-11-38633).

On the other hand, as for the productivity in the plate making operation of polymerization type lithographic printing plate precursor which is easy to perform development processing, it is important to reduce time necessary for the exposure step. In the case of such lithographic printing plate precursors, an inter leaf is conventionally used between the lithographic printing plate precursors, and time for removal of the inter leaf is inefficient in the exposure step. The inter leaf has a function of preventing adhesion of the lithographic printing plate precursors each other. Thus, improvement in adhesion resistance between the lithographic printing plate precursors has been desired in order to reduce time for removal of the inter leaf in the exposure step. Also, the lithographic printing plate precursor described in JP-A-11-38633 has low sensitivity and it has been desired to increase sensitivity.

JP 110-38645 A discloses a photosensitive material that is provided with a photopolymerizable layer and contains a laminar inorganic compound. Preferably, the photosensitive transfer material has a peelable layer, a photopolymerizable image-forming layer and a water-soluble protective layer in this order.

EP 1 518 672 A forms prior art pursuant to Art. 54(3) EPC for those embodiments of the present application, which are entitled to priority, and prior art pursuant to Art. 54(2) EPC for the remaining embodiments. This document discloses a lithographic printing plate precursor comprising a support, an image-recording layer comprising (A) an actinic ray absorber, (B) a polymerization initiator, and (C) a polymerizable compound, wherein the image-recording layer is capable of being removed with at least one of a printing ink and a fountain solution; and an overcoat layer comprising an inorganic laminar compound.

### SUMMARY OF THE INVENTION

The present invention aims at solving the above hitherto known problems and achieving the following objects.

Specifically, an object of the present invention is to provide a high-sensitive lithographic printing plate precursor capable of accepting writing with a laser (preferably a violet laser) wherein adhesion resistance of a back layer side thereof to a photosensitive layer side thereof is improved.

As a result of intensive investigations to achieve the above-described object, the inventor has found that the above-described object can be achieved by incorporating an inorganic stratiform compound into a protective layer.

Specifically, the lithographic printing plate precursor according to the invention comprises a hydrophilic support having coated in order thereon a photosensitive layer containing a sensitizing dye, a polymerization initiator, a chain transfer agent, a compound having an ethylenically unsaturated double bond and a polymer binder having a crosslinkable group, and a protective layer containing an inorganic stratiform compound, as defined in claim 1.

The term "having coated in order" as used herein means that the photosensitive layer and the protective layer are provided in this order on the support and it does not deny the presence of any layer provided depending on the purpose other than these layers, for example, an intermediate layer or a back coat layer.

In the invention, a coating amount of the protective layer is preferably from 0.5 g /m² to 2.0 g /m². Further, a content of the inorganic stratiform compound contained in the protective layer is preferably from 5% by weight to 55% by weight based on the coating amount of the protective layer.

Moreover, in the invention, the inorganic stratiform compound contained in the protective layer is preferably mica.

Although the function according to the invention is not quite clear, it is believed to be as follows.

It is believed that by incorporating the inorganic stratiform compound into the protective layer of the lithographic printing plate precursor according to the invention, the protective layer is provided with matting property and increases its hardness so that adhesion of a back layer side of the lithographic printing plate precursor to a photosensitive layer side thereof is prevented.

According to the present invention, a high-sensitive lithographic printing plate precursor capable of accepting writing with a laser, particularly a violet laser, wherein adhesion resistance of a back layer side thereof to a photosensitive layer side thereof is improved.

### DETAILED DESCRIPTION OF THE INVENTION

The lithographic printing plate precursor according to the present invention will be described in detail below.

The lithographic printing plate precursor of the invention is characterized in that in a lithographic printing plate precursor which comprises a hydrophilic support having coated in order thereon a photosensitive layer containing a sensitizing dye, a polymerization initiator, a chain transfer agent, a compound having an ethylenically unsaturated double bond and a polymer binder having a crosslinkable group, and a protective layer, the protective layer contains an inorganic stratiform compound, as defined in claim 1.

Each of members constituting the lithographic printing plate precursor will be described below.

### [Protective Layer]

A photosensitive layer of the lithographic printing plate precursor according to the invention is a negative-working photosensitive layer as described hereinafter. Thus, since exposure of the lithographic printing plate precursor is ordinarily conducted in the atmosphere, it is necessary to provide a protective layer (also referred to as an over coat layer) on the photosensitive layer for the purpose of preventing invasion of a low molecular compound that hinders an image-forming reaction, for example, oxygen or a basic substance present in the atmosphere, into the photosensitive layer. Characteristics desired to the protective layer include that it does not disturb transmission of light used for exposure, that it is excellent in adhesion to the photosensitive layer and that it can be easily removed in a development step after the exposure as well as it has low permeability of the low molecular compound, for example, oxygen.

The protective layer according to the invention contains an inorganic stratiform compound.

The inorganic stratiform compound used in the invention is a particle having a thin tabular shape and includes, for example, mica, for example, natural mica represented by following formula: A (B, C)₂₋₅ D₄ O₁₀ (OH, F, O)₂, (wherein A represents any one of K, Na and Ca, B and C each represents any one of Fe (II), Fe(III), Mn, Al, Mg and V, and D represents Si or Al) or synthetic mica; talc represented by following formula: 3MgO·4SiO·H₂O; teniolite; montmorillonit; saponite; hectolite; and zirconium phosphate.

Of the micas, examples of the natural mica include muscovite, paragonite, phlogopite, biotite and lepidolite. Examples of the synthetic mica include non-swellable mica, for example, fluorine phlogopite KM_{g3}(AlSi₃O₁₀)F₂ or potassium tetrasilic mica KM_{g2.5}(Si₄O₁₀)F₂, and swellable mica, for example, Na tetrasililic mica NaMg_{2.5}(Si₄O₁₀)F₂, Na or Li teniolite (Na, Li)Mg₂Li(Si₄O₁₀)F₂, or montmorillonit based Na or Li hectolite (Na, Li)_{1/8}Mg_{2/5}Li_{1/8}(Si₄O₁₀)F₂. Synthetic smectite is also useful.

Of the inorganic stratiform compounds, fluorine based swellable mica, which is a synthetic inorganic stratiform compound, is particularly useful in the invention. Specifically, the swellable synthetic mica and an swellable clay mineral, for example, montmorillonit, saponite, hectoliter or bentonite have a stratiform structure comprising a unit crystal lattice layer having thickness of approximately 10 to 15 angstroms and metallic atom substitution in the lattices is remarkably large in comparison with other clay minerals. As a result, the lattice layer results in lack of positive charge and to compensate it, cations, for example, Na⁺, Ca²⁺ or Mg²⁺, are adsorbed between the lattice layers. The cation existing between the lattice layers is referred to as an exchangeable cation and is exchangeable with various cations. In particular, in the case where the cation between the lattice layers is Li+ or Na⁺, a bond between the stratiform crystal lattices is week because of a small ionic radius, and the inorganic stratiform compound greatly swells upon contact with water. When share is applied under such condition, the stratiform crystal lattices are easily cleaved to form a stable sol in water. The bentnite and swellable synthetic mica have strong such tendency and are useful in the invention. Particularly, the swellable synthetic mica is preferably used.

With respect to the shape of the inorganic stratiform compound used in the invention, the thinner the thickness or the larger the plain size as long as smoothness of coated surface and transmission of actinic radiation are not damaged, the better from the standpoint of control of diffusion. Therefore, an aspect ratio of the inorganic stratiform compound is ordinarily 20 or more, preferably 100 or more, and particularly preferably 200 or more. The aspect ratio is a ratio of thickness to major axis of particle and can be determined, for example, from a projection drawing of particle by a microphotography. The larger the aspect ratio, the greater the effect obtained.

As for the particle size of the inorganic stratiform compound used in the invention, an average major axis is ordinarily from 0.3 to 20 µm, preferably from 0.5 to 10 µm, and particularly preferably from 1 to 5 µm. An average thickness of the particle is ordinarily 0.1 µm or less, preferably 0.05 µm or less, and particularly preferably 0.01 µm or less. For example, in the swellable synthetic mica that is the representative compound of the inorganic stratiform compounds, thickness is approximately from 1 to 50 nm and plain size is approximately from 1 to 20 µm.

By incorporating particles of the inorganic stratiform compound having a large aspect ratio into the protective layer, strength of coated layer increases and penetration of oxygen or water cam be effectively prevented, thereby preventing degradation of the protective layer due to deformation.

An amount of the inorganic stratiform compound contained in the protective layer is ordinarily from 5 to 55% by weight, preferably form 10 to 40% by weight, based on the total solid content of the protective layer. The amount of 5% by weight or more is sufficiently effective with respect to the adhesion resistance. The amount of 55% by weight or less provides good layer formation and good sensitivity. When a plural kind of the inorganic stratiform compounds is used together, it is preferred that the total amount of the inorganic stratiform compounds is in the range described above.

An example of ordinary dispersing method of the inorganic stratiform compound used in the protective layer is described below. Specifically, from 5 to 10 parts by weight of a swellable stratiform compound that is exemplified as a preferred inorganic stratiform compound is added to 100 parts by weight of water to adapt the compound to water and to be swollen, followed by dispersing using a dispersing machine. The dispersing machine used include, for example, a variety of mills conducting dispersion by directly applying mechanical power, high-speed agitation type dispersing machine providing a large shear force and a dispersion machine providing ultrasonic energy of high intensity. Specific examples thereof include ball mill, sand grinder mill, visco mill, colloid mill, homogenizer, dissolver, polytron, homomixer, homoblender, keddy mill, jet agitor, capillary emulsifying device, liquid siren, electromagnetic strain type ultrasonic generator, and emulsifying device having Polman whistle. A dispersion containing 5 to 10% by weight of the inorganic stratiform compound thus prepared is highly viscous or gelled and exhibits extremely good preservation stability. In the formation of a coating solution for protective layer using the dispersion, it is preferred that the dispersion is diluted with water, sufficiently stirred and then blended with a binder solution.

In the protective layer used in the invention, a binder is used in order to achieve film-forming property. The binder is not particularly restricted as long as it has good dispersibility of the inorganic stratiform compound and is capable of forming a uniform layer closely contact with the photosensitive layer. Any water-soluble polymer and water-insoluble polymer can be appropriately selected to use. Among them, a polymer having oxygen-shielding property is more preferable. Specifically, a water-soluble polymer, e.g., polyvinyl alcohol, polyvinyl pyrrolidone, acidic cellulose, gelatin, gum Arabic or polyacrylic acid is exemplified. Of the compounds, when polyvinyl alcohol is used as a main component, the best results can be obtained in view of oxygen-shielding property, removability upon development, dispersibility of the inorganic stratiform compound and the like.

Polyvinyl alcohol for use in the protective layer may be partially substituted with ester, ether and acetal as long as they contain unsubstituted vinyl alcohol units for obtaining the necessary oxygen-shielding property and water solubility. Also, a part of polyvinyl alcohol may have other copolymer component. As specific examples of polyvinyl alcohol, those having hydrolyzing rate of 71 to 100% by mole and molecular weight of 300 to 2,400 can be exemplified. Specifically, examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, L-8, KL-318 and KL-506 (trade names, manufactured by Kuraray Co., Ltd.).

An amount of the inorganic stratiform compound contained in the protective layer is preferably from 5/1 to 1/100 in terms of a weight ratio to the amount of the binder used in the protective layer. In the above range, sufficient effect can be achieved. When a plural kind of the inorganic stratiform compounds is used together, it is preferred that the total amount of the inorganic stratiform compounds is in the weight ratio range described above.

To the coating solution for protective layer can be added known additives, for example, a surfactant for improving coating property or a water-soluble plasticizer for improving physical property of coated layer. Examples of the water-soluble plasticizer include propionamide, cyclohexanediol, glycerin or sorbitol. Also, a water-soluble (meth)acrylic polymer may be added. Further, to the coating solution may be added known additives for improving time-lapse stability of the coating solution.

A coating method of the protective layer used in the invention is not particularly restricted and methods described in U.S. Patent 3,458,311 and JP-B-55-49729 can be utilized.

A coating amount (after drying) of the protective layer is ordinarily from 0.5 to 2.0 g/m², preferably from 0.75 to 1.5 g/m². In the above range, the film strength of protevtive layer is maintained, scratch resistance is excellent, and good image quality is obtained.

The protective layer used in the invention has good adhesion to the photosensitive layer and excellent oxygen and moisture-shielding property. Also it is transparent to actinic radiation used for writing on the photosensitive layer so that it has a characteristic that does not disturb the writing function.

### [Photosensitive Layer]

The photosensitive layer according to the invention is a polymerizable negative-working photosensitive layer containing as the essential components, a sensitizing dye, a polymerization initiator, a chain transfer agent, a compound having an ethylenically unsaturated double bond and a polymer binder having a crosslinkable group, and if desired, further containing a coloring agent and other optional components, as defined in claim 1.

Each component constituting the photosensitive layer of the lithographic printing plate precursor according to the invention will be described below.

### [Sensitizing Dye]

The photosensitive layer used in the invention contains a sensitizing dye in order to increase photosensitivity. It is preferred that the sensitizing dye responds to a violet laser beam. Of such sensitizing dyes, sensitizing dyes having an absorption maximum in a wavelength range of 300 to 500 nm are described at the beginning. Examples of the sensitizing dye include cyanine dyes represented by formula (S1) shown below, benzopyranes represented by formula (S2) shown below, coumarins, aromatic ketones represented by formula (S3) shown below, and anthracenes represented by formula (S4) shown below.

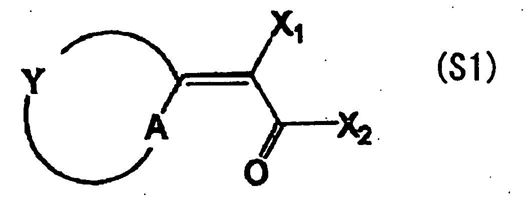

In formula (S1), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye.

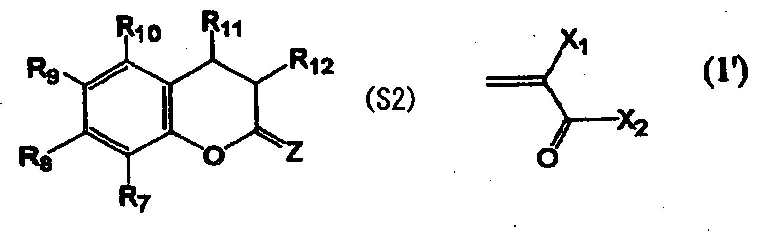

In formula (S2), =Z represents a carbonyl group, a thiocarbonyl group, an imino group or an alkylydene group represented by the partial structural formula (I') described above, X₁ and X₂ have the same meanings as defined in formula (S1), and R₇ to R₁₂ each independently represents a monovalent non-metallic atomic group.

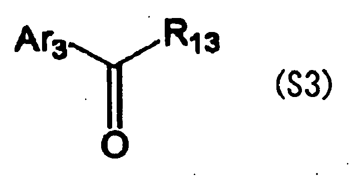

In formula (S3), Ar₃ represents an aromatic group which may have a substituent or a heteroaromatic group which may have a substituent, and R₁₃ represents a monovalent non-metallic atomic group. More preferably, R₁₃ represents an aromatic group or a heteroaromatic group or Ar₃ and R₁₃ may be combined with each other to form a ring.

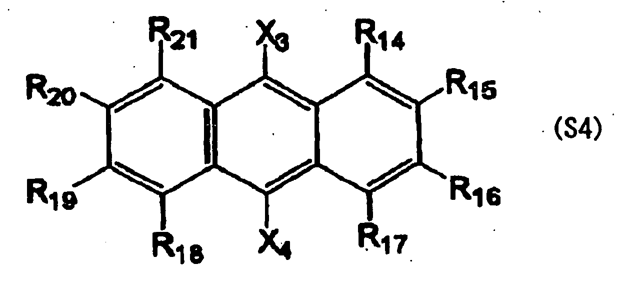

In formula (S4), X₃, X₄ and R₁₄ to R₂₁ each independently represents a monovalent non-metallic atomic group. More preferably, X₃ and X₄ each independently represents an electron-donating group having a negative Hammett substituent constant.

In formulae (S1) to (S4), preferred examples of the monovalent non-metallic atomic group represented by X₁ to X₄ and R₆ to R₂₁ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methyl-carbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropyl-sulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group or a phosphonatophenyl group), a heteroaryl group (for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diaryl-carbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, and a nitro group. Of the substituents, a hydroxy group, an alkyl group, an aryl group, a halogen atom, an alkoxy group and an acyl group are particularly preferred.

The basic nucleus of the dye formed by Y together with the adjacent A and the adjacent carbon atom includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole) or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6',4,5-thiazole); oxazoles (for example, 4-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole or 6-hydroxybenzoxazole); naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1]selenazole); thiazolines (for example, thiazoline or 4-methylthiazoline); 2-quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); 4-quinolines (for example, quinoline, 6-methoxyquinoline, 7-methylquinoline or 8-methylquinoline); 1-isoquinolines (for example, isoquinoline or 3,4-dihydroisoquinoline); 3-isoquinolines (for example, isoquinoline); benzimidazoles (for example, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolenine); 2-pyridines (for example, pyridine or 5-methylpyridine); and 4-pyridines (for example, pyridine).

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthodithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Of the sensitizing dyes having an absorption maximum in a wavelength range of 360 to 450 nm, dyes represented by formula (S5) shown below are more preferred in view of high sensitivity.

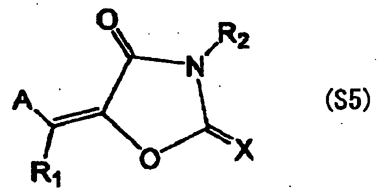

In formula (S5), A represents an aromatic ring which may have a substituent or a hetero ring which may have a substituent, X represents an oxygen atom, a sulfur atom or N-(R₃), R₁, R₂ and R₃ each independently represents a hydrogen atom or a monovalent non-metallic atomic group, or A and R₁ or R₂ and R₃ may be combined with each other to form an aliphatic or aromatic ring.

The formula (S5) will be described in more detail below. R₁, R₂ and R₃ each independently represents a hydrogen atom or a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic group, a substituted or unsubstituted alkoxy group, a substituted or unsubstituted alkylthio group, a hydroxy group or a halogen atom.

Preferred examples of R₁, R₂ and R₃ will be specifically described below. Preferred examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group exclusive of a hydrogen atom is used. Preferred examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group and a phosphonatophenyl group.

Preferred examples of the aromatic heterocyclic group represented by any one of R₁, R₂ and R₃ include a monocyclic or polycyclic aromatic ring containing at least one of a nitrogen atom, an oxygen atom and a sulfur atom. Examples of especially preferred aromatic heterocyclic group include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane and phenoxazine. These groups may be benzo-fused or may have a substituent.

Also, preferred examples of the alkenyl group represented by any one of R₁, R₂ and R₃ include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of G₁ in the acyl group (G₁CO-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphonato group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferred alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferred substituted alkyl group represented by any one of R₁, R₂ and R₃, which is obtained by combining the above-described substituent with an alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methyl-carbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropyl-sulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferred examples of the aryl group represented by any one of R₁, R₂ and R₃ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferred substituted aryl group represented by any one of R₁, R₂ and R₃ include aryl groups having a monovalent non-metallic atomic group exclusive of a hydrogen atom as a substituent on the ring-forming carbon atom of the above-described aryl group. Preferred examples of the substituent include the above-described alkyl groups and substituted alkyl groups, and the substituents described for the above-described substituted alkyl group. Specific examples of the preferred substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allyl group, a 1-propenylmethyl group, a 2-butenyl group, a 2-methylallylphenyl group, a 2-methylpropenylphenyl group, a 2-propenylphenyl group, a 2-butynylphenyl group and a 3-butynylphenyl group.

Next, A in formula (S5) will be described below. A represents an aromatic ring which may have a substituent or hetero ring which may have a substituent. Specific examples of the aromatic ring which may have a substituent or hetero ring which may have a substituent include those described for any one of R₁, R₂ and R₃ in formula (S5).

The sensitizing dye represented by formula (S5) according to the invention is obtained by a condensation reaction of the above-described acidic nucleus or an active methyl group-containing acidic nucleus with a substituted or unsubstituted, aromatic ring or hetero ring and can be synthesized with reference to JP-B-59-28329.

Preferred specific examples (D1) to (D38) of the compound represented by formula (S5) are set forth below. Also, when isomers with respect to a double bond connecting an acidic nucleus and a basic nucleus are present, the invention should not be construed as being limited to any one of the isomers.

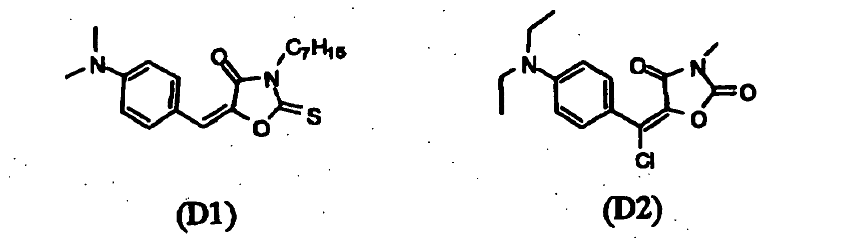

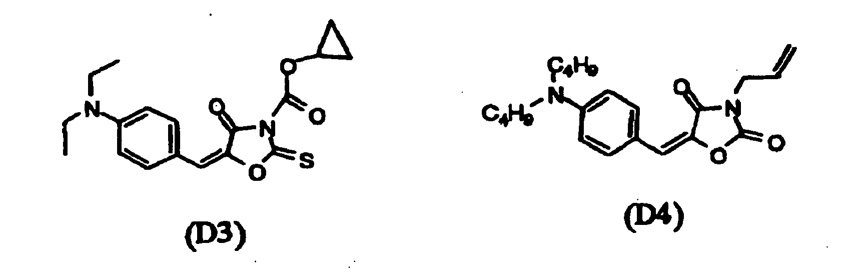

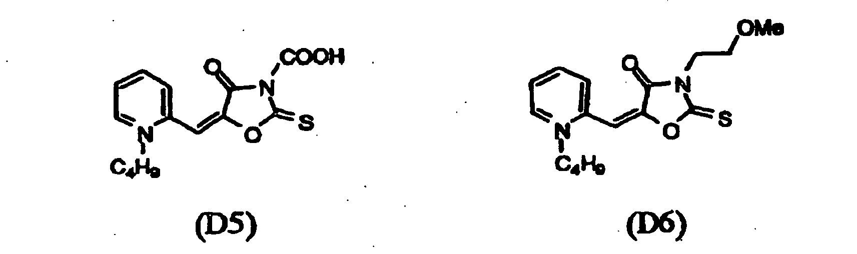

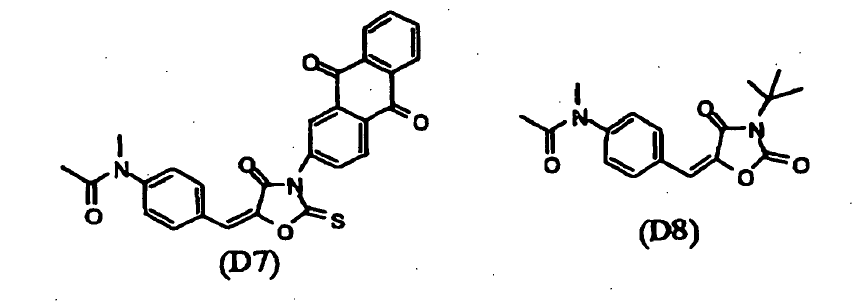

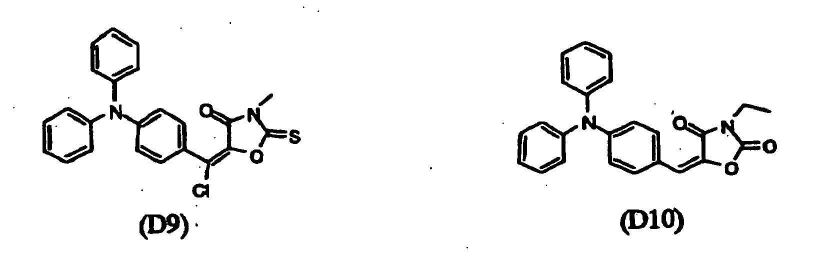

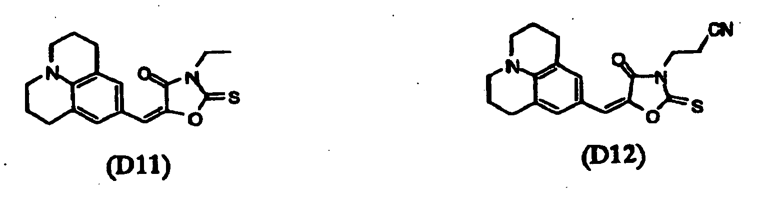

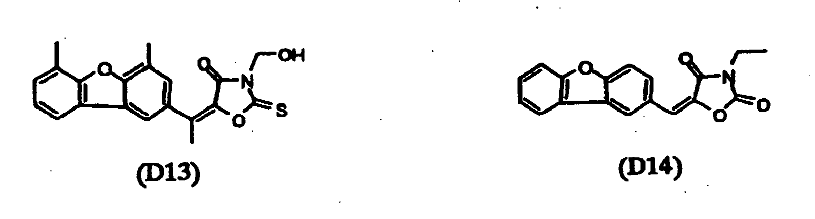

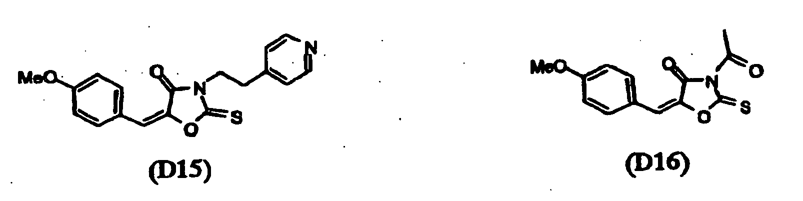

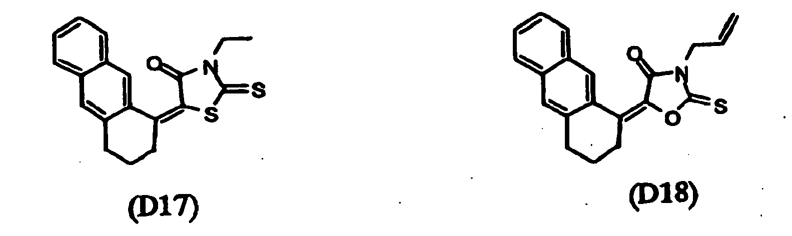

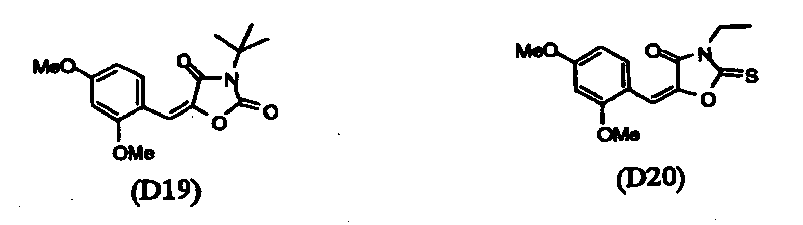

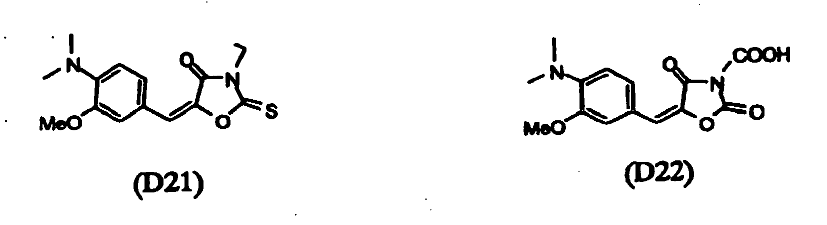

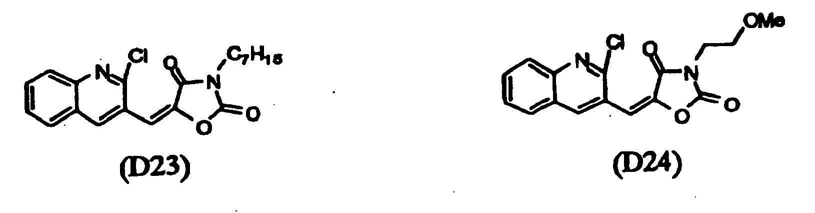

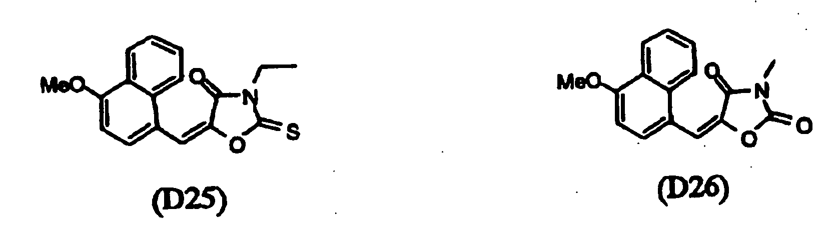

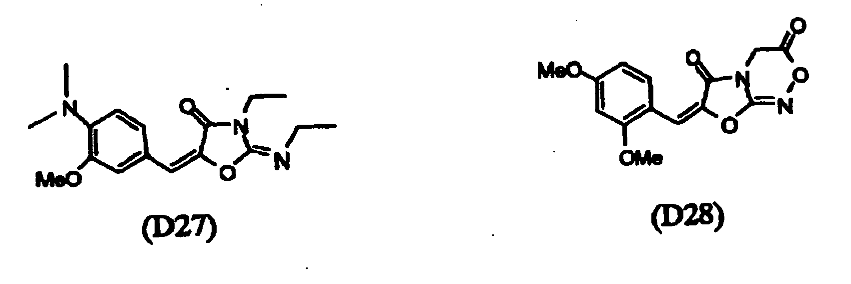

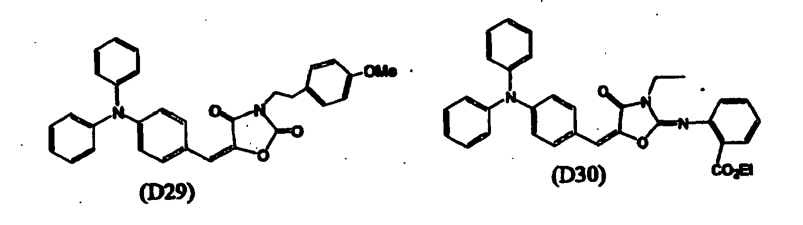

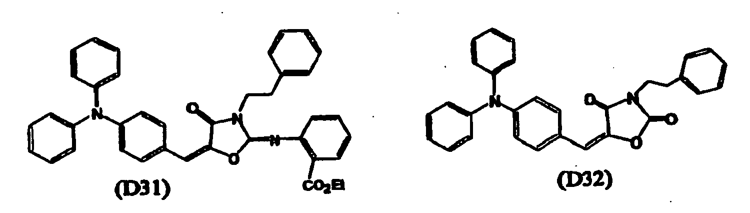

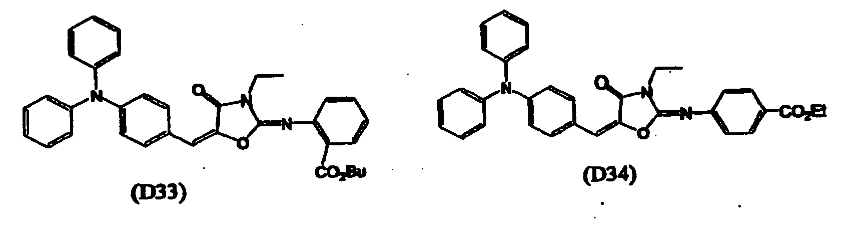

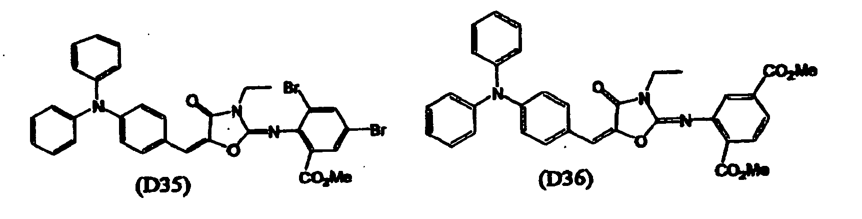

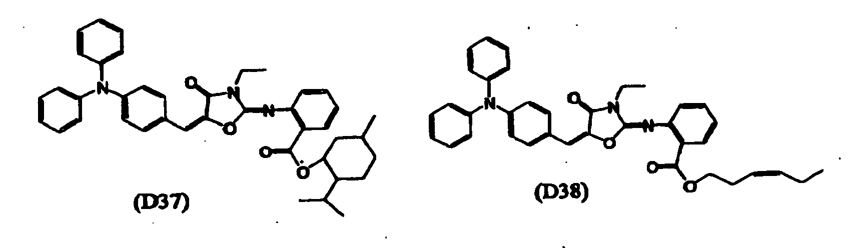

### [Compound Having Ethylenically Unsaturated Double Bond]

The compound having an ethylenically unsaturated double bond (hereinafter, also referred to as an "ethylenically unsaturated compound") is a compound having an ethylenically unsaturated bond, which is addition-polymerized by the action of a polymerization initiator to crosslink or harden, when the photosensitive layer is irradiated with active radiation. The compound having an addition-polymerizable ethylenically unsaturated bond can be appropriately selected from compounds having at least one, preferably two or more terminal ethylenically unsaturated bonds. The compound has a chemical form, for example, a monomer, a prepolymer (i.e., dimmer, trimer or oligomer), or a mixture thereof.

Examples of the monomer include esters between an unsaturated carboxylic acid (for example, acrylic acid, methacrylic acid, itaconic acid, crotonic acid, isocrotonic acid or maleic acid) and an aliphatic polyhydric alcohol compound and amides between an unsaturated carboxylic acid and an aliphatic polyamine compound.

Specific examples of the monomer of the ester between an aliphatic polyhydric alcohol compound and an unsaturated carboxylic acid include acrylates, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate or polyester acrylate oligomer;
methacrylates, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane or bis-[p-(methacryloxyethoxy)phenyl]dimethylmethane; itaconates, for example, ethylene glydcol diitaconate, propylene glycol diitaconate, 1,5-butanediol diitaconate, 1,4-butanediol diitaconate, tetramethylene glycol diitaconate, pentaerythritol diitaconate or sorbitol tetraitaconate; crotonatates, for example, ethylene glycol dicrotonate, tetramethylene glycol dicrotonate, pentaerythritol dicrotonate or sorbitol tetradicrotonate; isocrotonates, for example, ethylene glycol diisocrotonate, pentaerythritol diisocrotonate or sorbitol tetraisocrotonate;
and maleates, for example, ethylene glycol dimaleate, triethylene glycol dimaleate, pentaerythritol dimaleate or sorbitol tetramaleate. Further, mixtures of the ester monomers are exemplified. Also, specific examples of the monomer of the amide between an aliphatic polyamine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide.

In addition, vinylurethane compounds having two or more polymerizable vinyl groups per molecule described in JP-B-48-41708, which are obtained by adding a hydroxy group-containing vinyl monomer represented by formula (A) shown below to a polyisocyanate compound having two or more isocyanato groups per molecule.

CH₂=C(R)COOCH₂CH(R')OH (A)

wherein R and R' each independently represents H or CH₃.
Also, urethane acrylates described in JP-A-51-37193 and JP-B-2-32293, polyester acrylates described in JP-A-48-64183, JP-B-49-43191 and JP-B-52-30490, and polyfunctional acrylates or methacrylates, for example, epoxyacrylates obtained by reacting an epoxy resin with (meth)acrylic acid are set forth. Further, photo-curable monomers and oligomers described in Nippon Secchaku Kyokaishi, Vol. 20, No. 7, pages 300 to 308 (1984) may be used.
The compound having an ethylenically unsaturated bond is ordinarily used in an amount of from 5 to 80% by weight, preferably from 30 to 70% by weight, based on the total weight of the photosensitive layer.

### [Polymer Binder]

The polymer binder used in the photosensitive layer is a polymer binder having a crosslinkable group in a side chain. By introducing the crosslinkable group into the side chain, three-dimensional crosslinkage upon actinic radiation is promoted so that strength of the hardened layer can be increased. The crosslinkable group includes a functional group capable of conducting an addition polymerization reaction, for example, an ethylenically unsaturated bonding group, an amino group or an epoxy group. Also, a functional group selected from a hydroxy group, a phosphonic acid group, a phosphoric acid group, a carbamoyl group, an isocyanate group, a ureido group, a ureylene group, a sulfonic acid group and an ammonio group is useful. Further, a functional group capable of forming a radical upon irradiation with light may be used. Such a crosslinkable group includes, for example, a thiol group, a halogen atom and an onium salt structure.

Among them, the ethylenically unsaturated bonding group is preferable, and functional groups represented by formulae (1) to (3) shown below are particularly preferable.

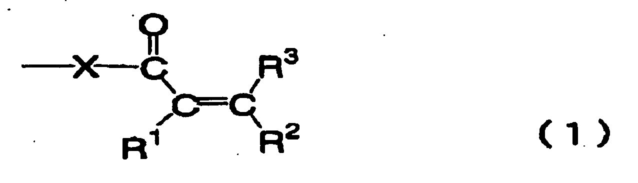

In formula (1), R¹ to R³ each independently represents a monovalent organic group. R¹ preferably includes, for example, a hydrogen atom or an alkyl group which may have a substituent. Among them, a hydrogen atom or a methyl group is preferable because of high radical reactivity. R² and R³ each independently preferably includes, for example, a hydrogen atom, a halogen atom, an amino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

X represents an oxygen atom, a sulfur atom or -N(R¹²)-, and R¹² represents a hydrogen atom or a monovalent organic group. The organic group represented by R¹² includes, for example, an alkyl group which may have a substituent. Among them, a hydrogen atom, a methyl group, an ethyl group or an isopropyl group is preferable because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxy group, an alkoxycarbonyl group, a sulfo group, a nitro group, a cyano group, an amido group, an alkylsulfonyl group and an arylsulfonyl group.

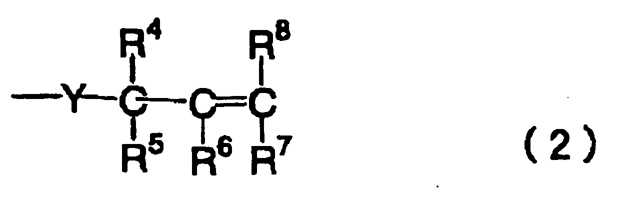

In formula (2), R⁴ to R⁸ each independently represents a hydrogen atom or a monovalent organic group. R⁴ to R⁸ each independently preferably includes, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable.

Examples of the substituent introduced include those described in Formula (1). Y represents an oxygen atom, a sulfur atom or -N(R¹²)-, and R¹² has the same meaning as R¹² defined in Formula (1). Preferred examples for R¹² are also same as those described in Formula (1).

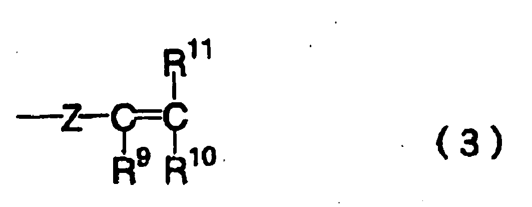

In formula (3), R⁹ represents a hydrogen atom or a monovalent organic group and preferably represents a hydrogen atom or an alkyl group which may have a substituent. Among them, a hydrogen atom or a methyl group is preferable because of high radical reactivity. R¹⁰ and R¹¹ each independently represents, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

Examples of the substituent introduced include those described in Formula (1). Z represents an oxygen atom, a sulfur atom, -N(R¹³)- or a phenylene group which may have a substituent. R¹³ preferably includes an alkyl group which may have a substituent. Among them, a methyl group, an ethyl group or an isopropyl group is preferable because of high radical reactivity.

As the polymer binder having a crosslinkable group in a side chain, urethane resins and acrylic resins are preferable from the standpoint that development damage in the exposed area can be prevented without accompanying with decrease in developing property in the unexposed area so that both good stain resistance and high printing durability can be achieved, even when an acid value of the photosensitive layer is low. The urethane resins are more preferable because a strong layer surface can also be obtained.

The urethane resin used in the invention is a polyurethane resin comprising a structural unit represented by a reaction product of at least one diisocyanate compound represented by formula (4) shown below and at least one diol compound represented by formula (5) shown below, as a basic skeleton.

OCN-X⁰-NCO (4)

HO-Y⁰-OH (5)

In formulae (4) and (5), X⁰ and Y⁰ each independently represents a divalent organic residue.

When at least one of the diisocyanate compound represented by formula (4) described above and the diol compound represented by formula (5) described above has at least one of the functional groups represented by formulae (1) to (3), a specific polyurethane resin having the functional group represented by formulae (1) to (3) introduced in the side chain is prepared as the reaction product of the diisocyanate compound and the diol compound. According to the method, the specific polyurethane resin according to the invention can be easily produced in comparison with a method wherein a desired side chain is substituted to introduce after the preparation of polyurethane resin.

### 1) Diisocyanate compound

The diisocyanate compound represented by formula (4) is a reaction product obtained, for example, by an addition reaction of triisocyanate compound with one equivalent of a monofunctional alcohol or monofunctional amine having an unsaturated group.

Examples of the triisocyanate compound are set forth below, but the invention should not be construed as being limited thereto.

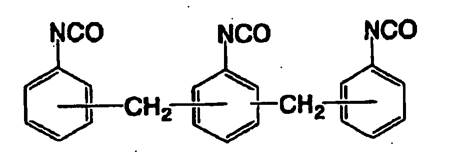

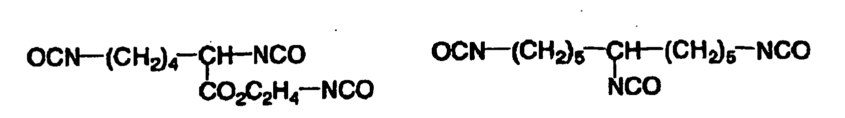

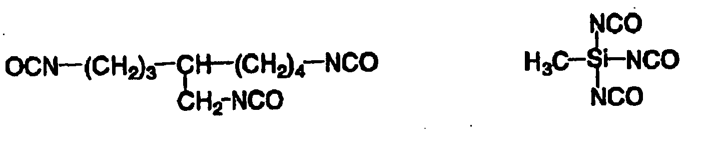

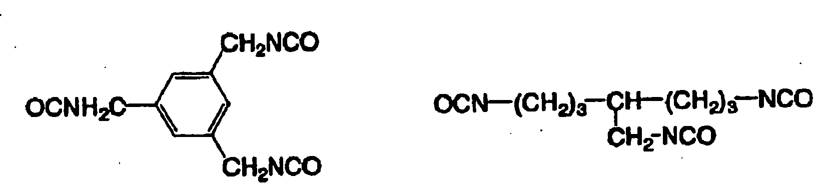

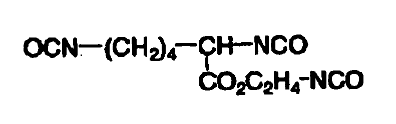

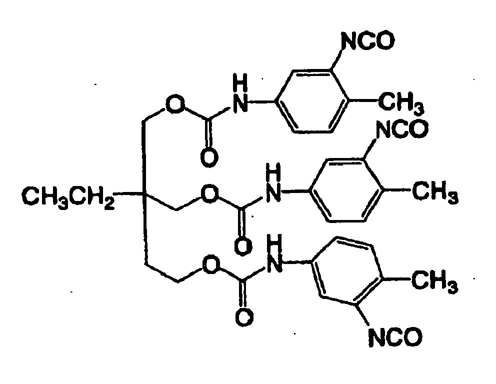

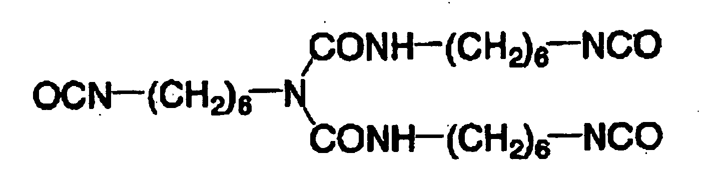

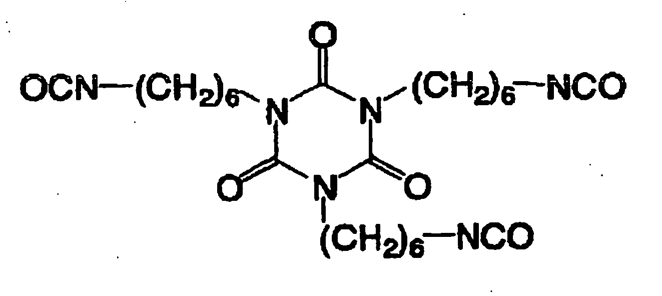

Examples of the monofunctional alcohol or monofunctional amine having an unsaturated group are set forth below, but the invention should not be construed as being limited thereto. 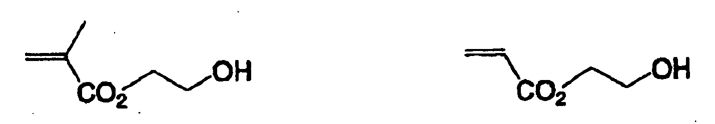 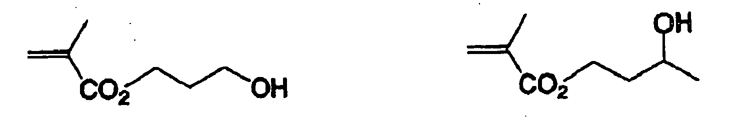 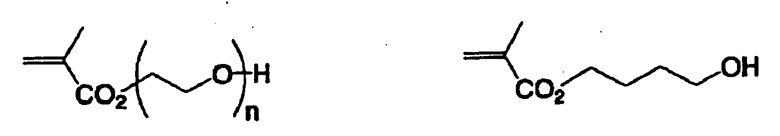 n is an integer of from 2 to 10.

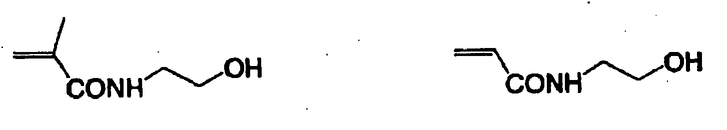

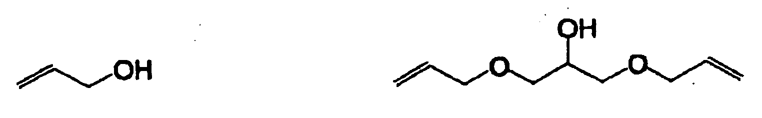

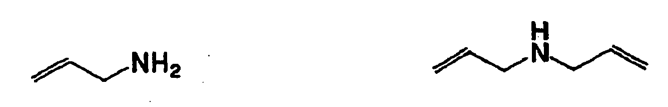

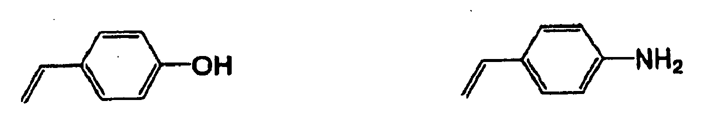

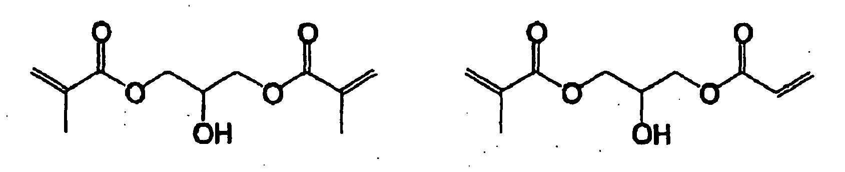

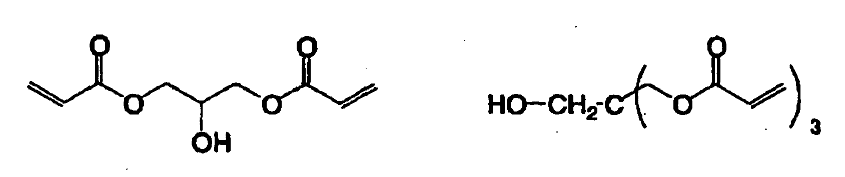

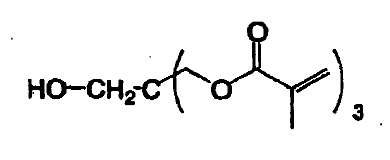

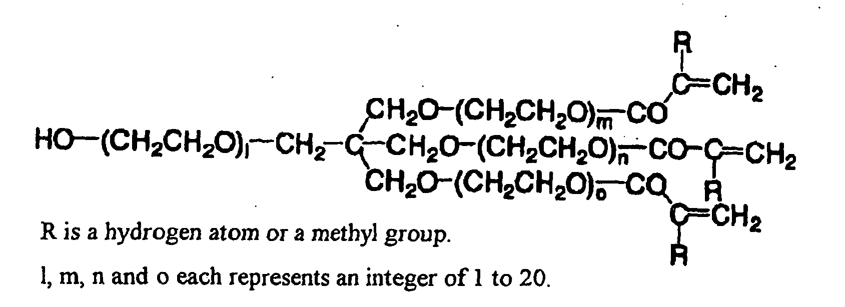

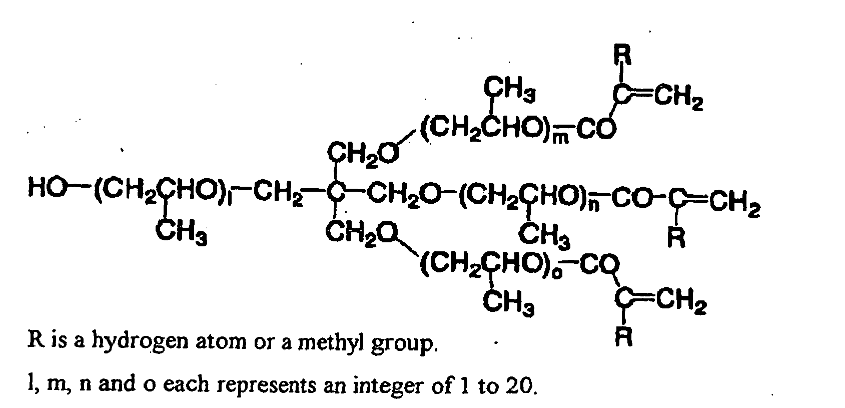

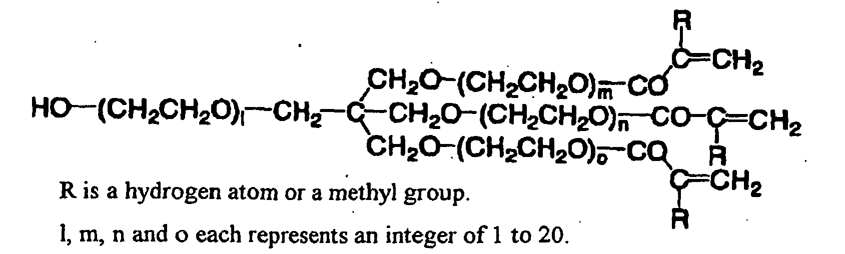

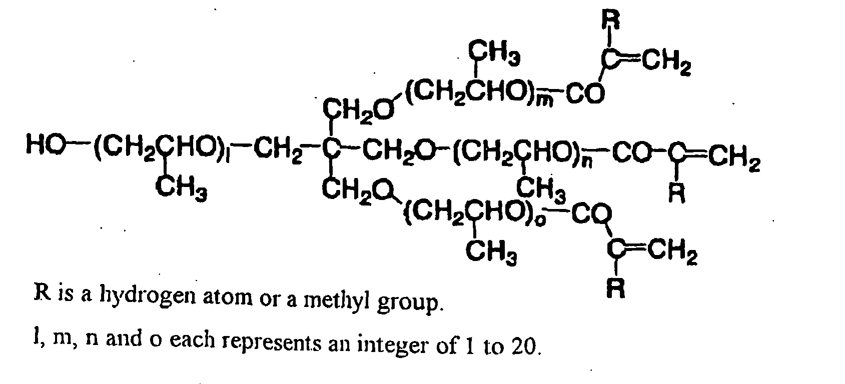

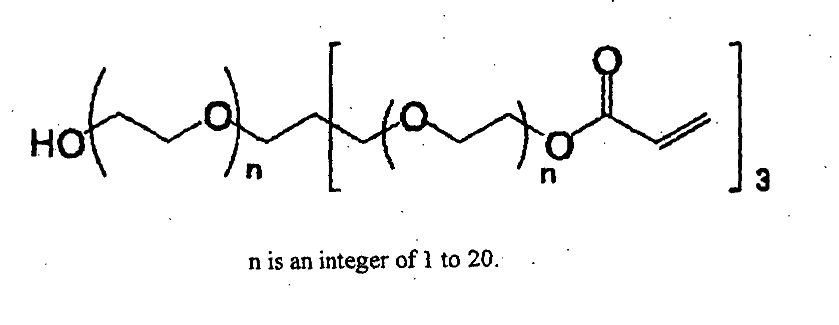

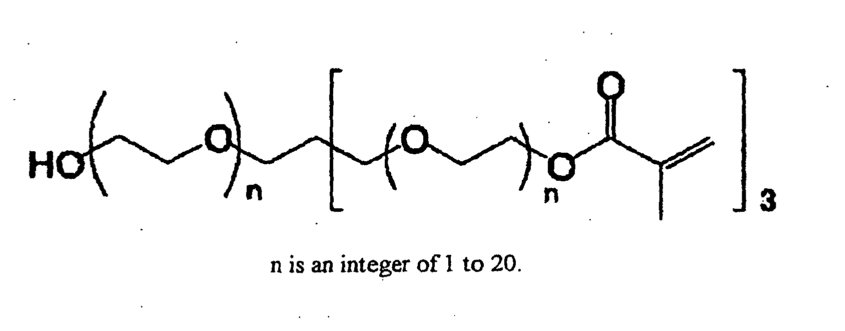

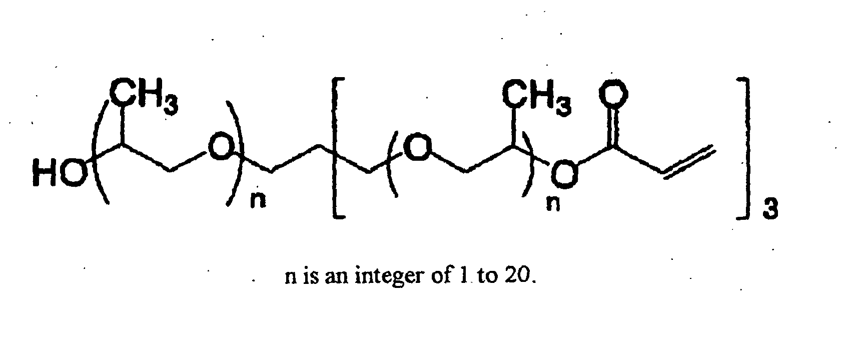

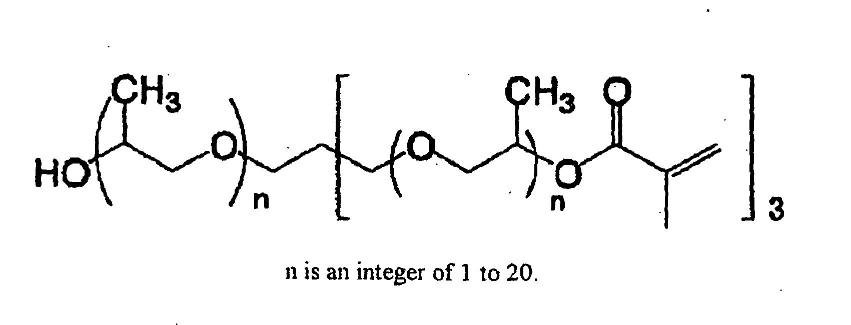

In order to introduce an unsaturated group into the side chain of the polyurethane resin, a method of using as a raw material for the production of polyurethane resin, the diisocyanate compound having the unsaturated group in the side chain is preferable. Specific examples of the diisocyanate compound having an unsaturated group in the side chain obtained by an addition reaction of triisocyanate compound with one equivalent of a monofunctional alcohol or monofunctional amine having the unsaturated group are set forth below, but the invention should not be construed as being limited thereto.

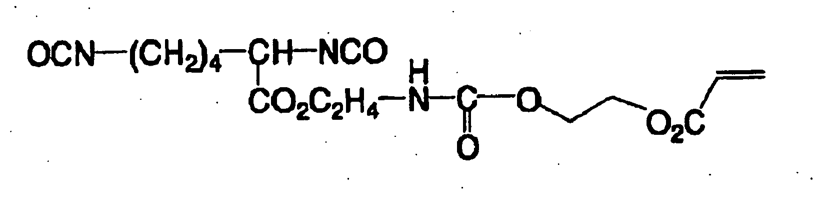

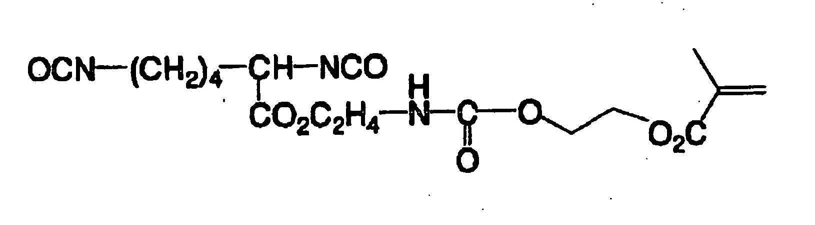

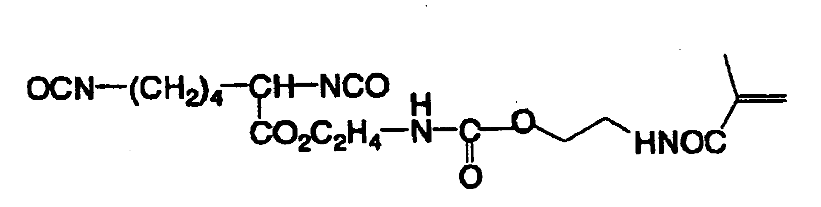

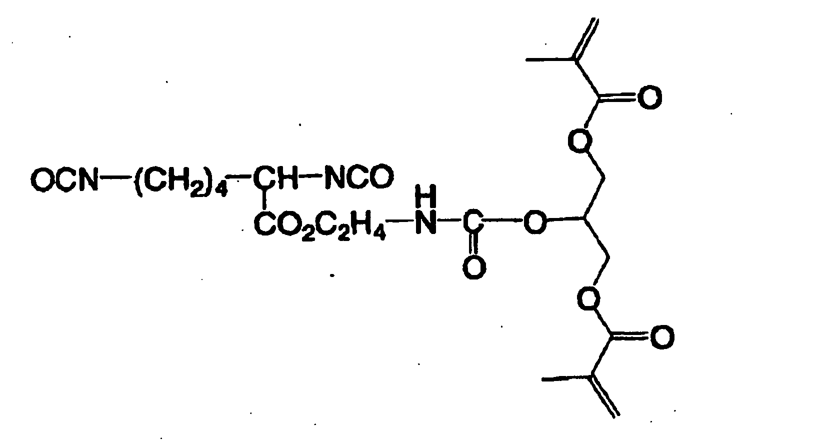

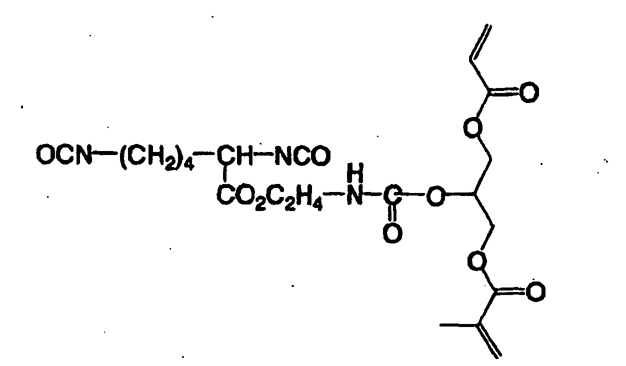

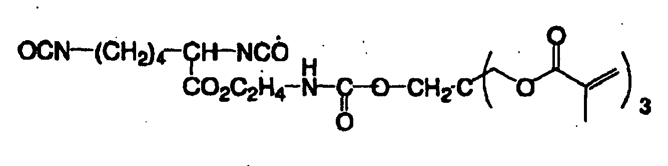

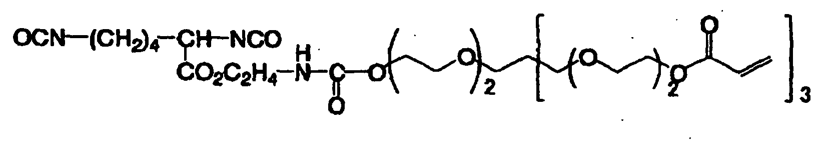

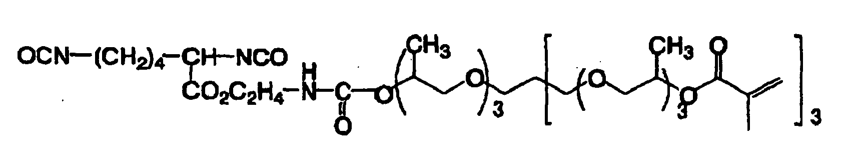

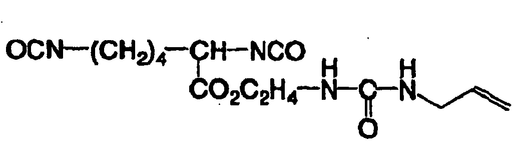

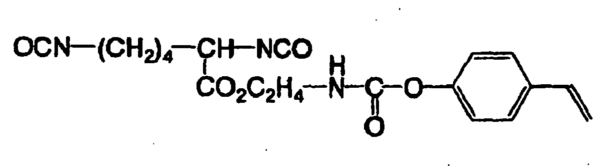

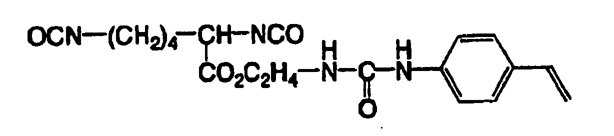

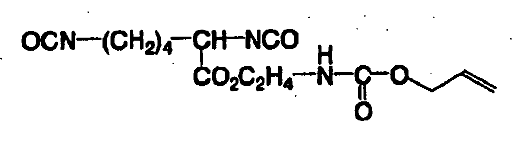

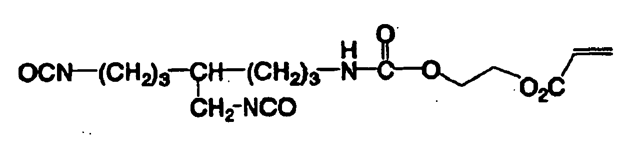

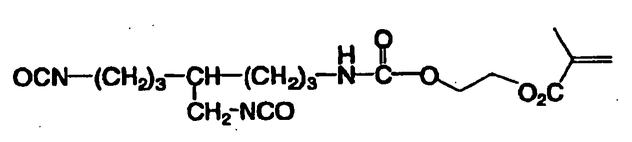

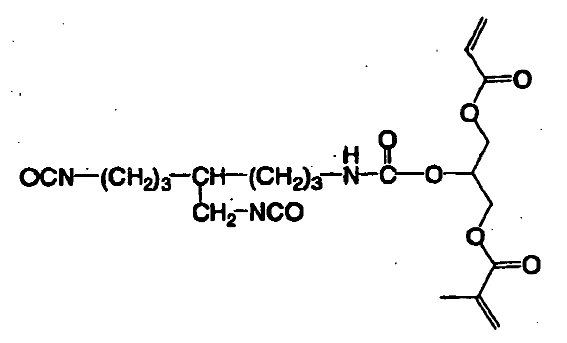

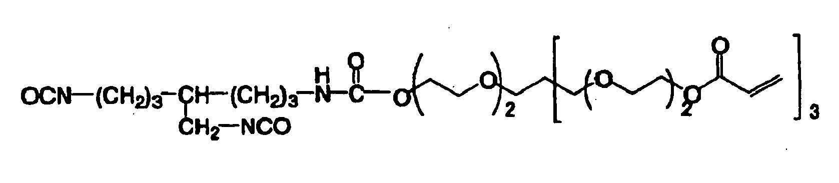

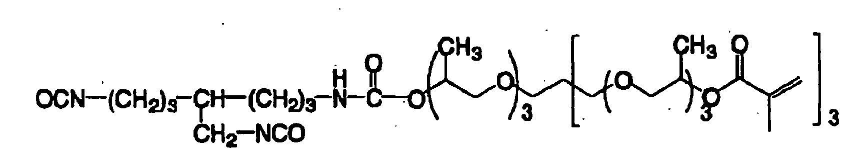

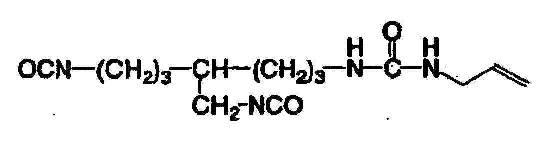

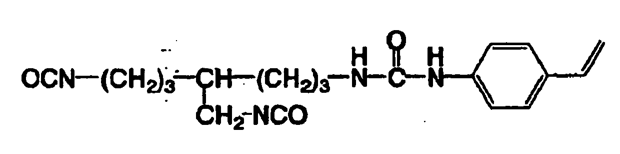

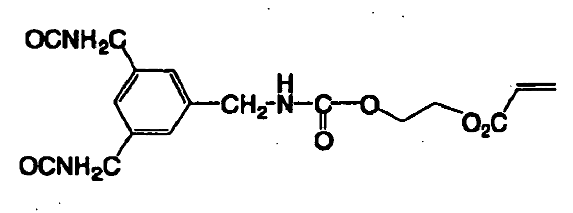

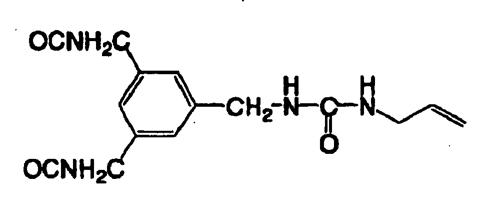

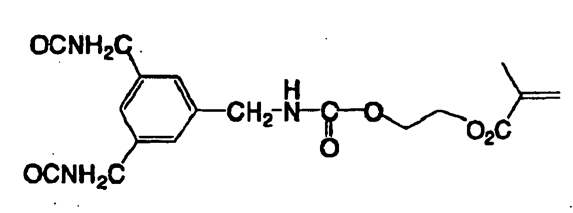

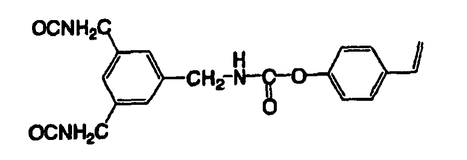

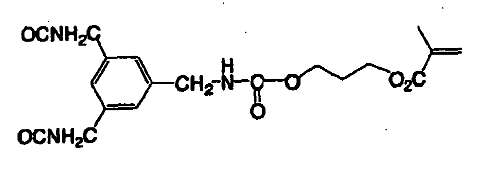

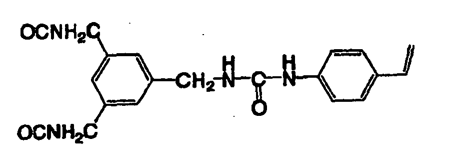

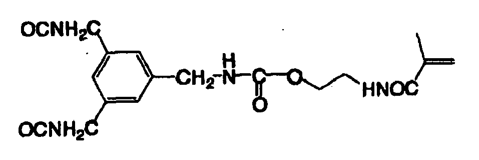

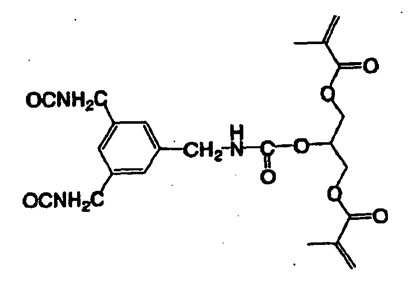

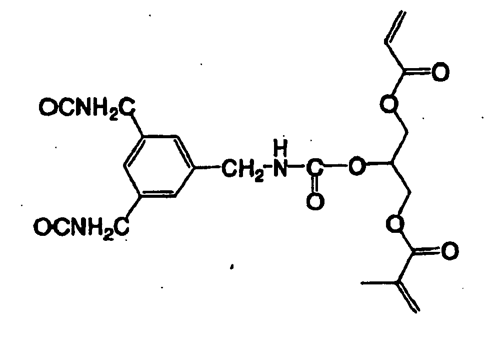

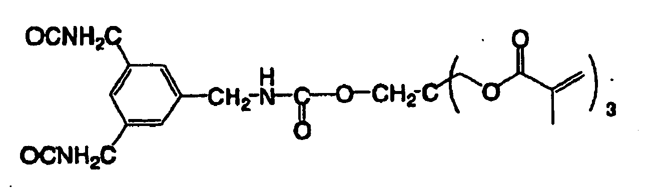

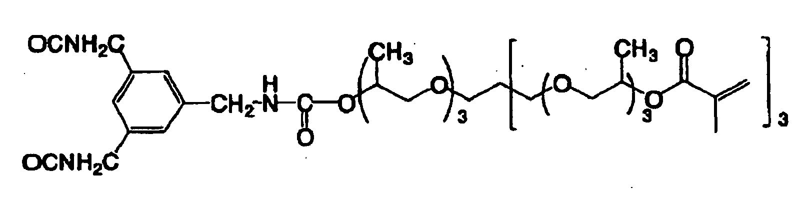

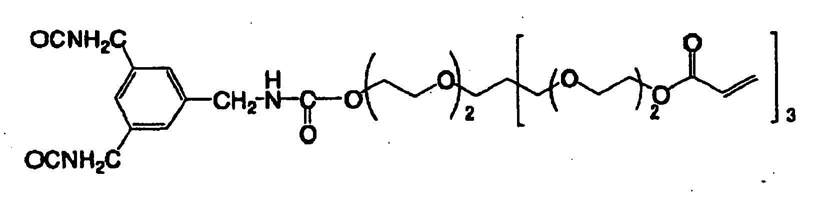

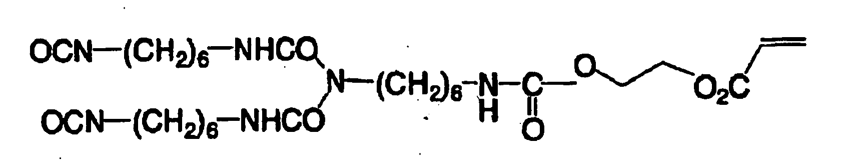

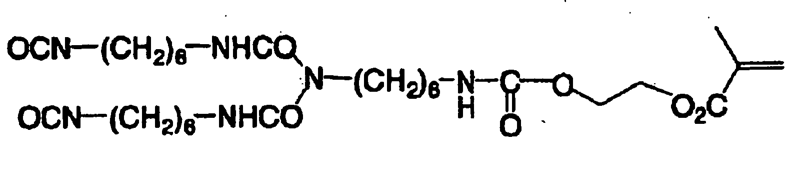

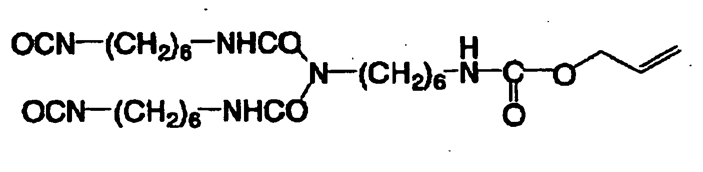

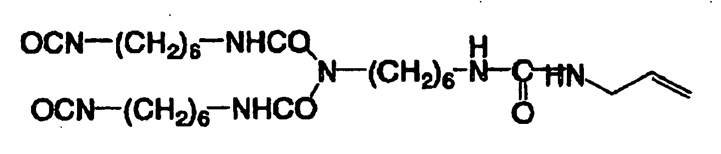

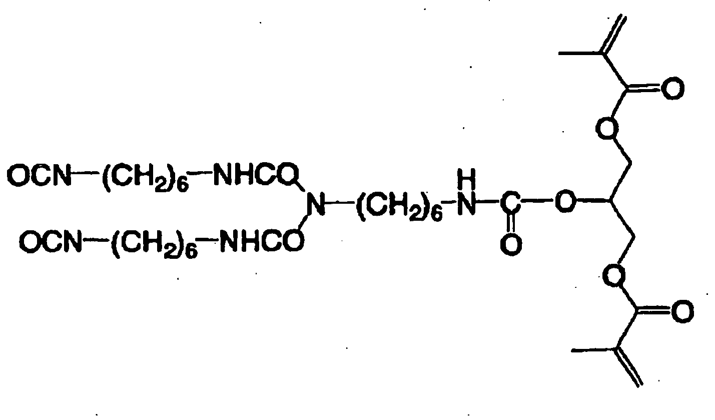

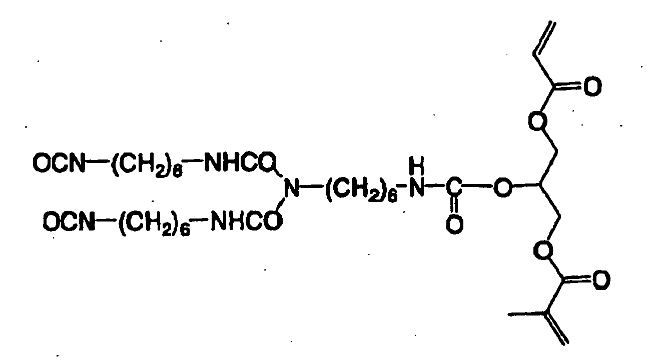

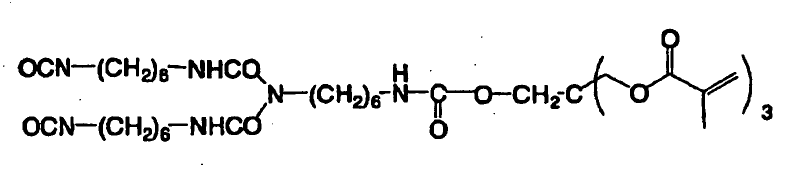

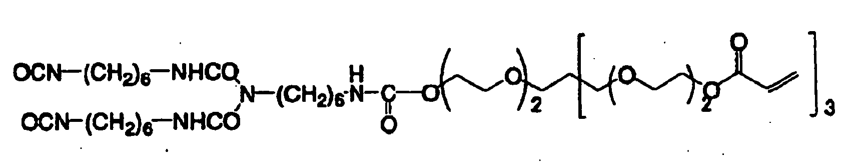

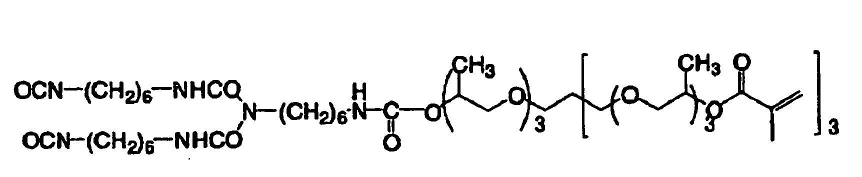

In the polyurethane resin used in the invention, a diisocyanate compound other than the above-described diisocyanate compound having an unsaturated group may be copolymerized in view of, for example, increase in compatibility with other components in the photosensitive layer and improvement in preservation stability.

The diisocyanate compound to be copolymerized includes compounds described below. Diisocyanate compounds represented by formula (6) shown below are preferable.

OCN-L₁-NCO (6)

In formula (6), L₁ represents a divalent aliphatic or aromatic hydrocarbon group which may have a substituent. If desired, L₁ may contain other functional group which does not react with the isocyanate group, for example, an ester group, a urethane group, an amido group or a ureido group.

Specific examples of the diisocyanate compound represented by formula (6) include the following compounds.

Specifically, an aromatic diisocyanate compound, for example, 2,4-tolylene diisocyanate, dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthalene diisocyanate or 3,3'-dimethylbiphenyl-4,4'-diisocyanate; an aliphatic diisocyanate compound, for example, hexamethylene diisocyanate, trimethylhexamethylene diisocyanate, lysine diisocyanate or dimeric acid diisocyanate; an alicyclic diisocyanate compound, for example, isophorone diisocyanate, 4,4'-methylenebis(cyclohexyl isocyanate), methylcyclohexane-2,4(or 2,6)-diisocyanate or 1,3-(isocyanatomethyl)cyclohexane; and a diisocyanate compound obtained by a reaction of diol with diisocyanate, for example, an adduct of 1 mole of 1,3-butylene glycol and 2 moles of tolylene diisocyanate are exemplified.

### 2) Diol Compound

As the diol compound represented by formula (5), which is a raw material of the polyurethane resin used in the invention, a diol compound selected from a diol compound having at least one crosslinkable group, a diol compound having at least one carboxy group and other diol compounds is used.

A method of using the diol compound having a crosslinkable group as the raw material of the polyurethane resin is preferable as well as the method described above for the purpose of introducing the crosslinkable group into the side chain of polyurethane resin. Such a diol compound can be easily produced by a reaction of a halogenated diol compound, a triol compound or an aminodiol compound with a carboxylic acid, acid chloride, isocyanate, alcohol, amine, thiol or halogenated alkyl compound having an unsaturated group. Specific examples of the diol compound having a crosslinkable group include trimethylolpropane monoallyl ether, trimethylolpropane monoacrylate, trimethylolpropane monomethacrylate, glycerin monoacrylate, glycerin monomethacrylate, and compounds set forth below, but the invention should not be construed as being limited thereto.

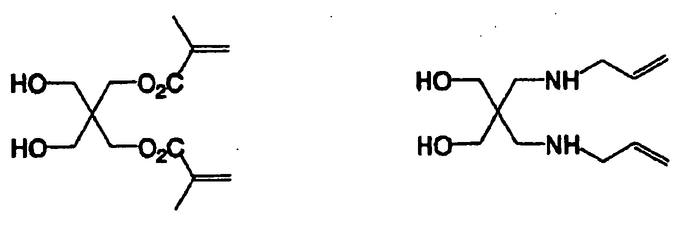

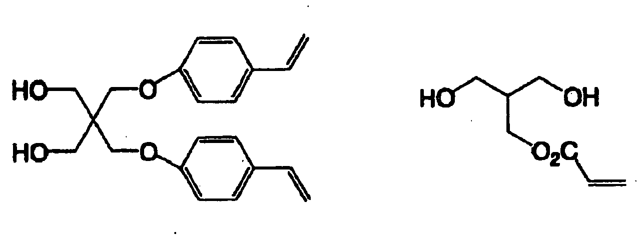

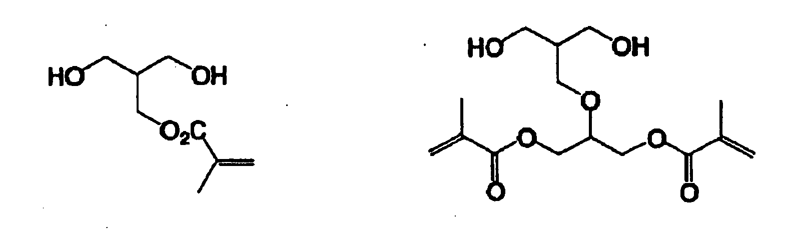

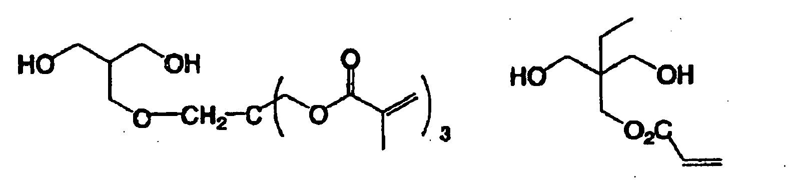

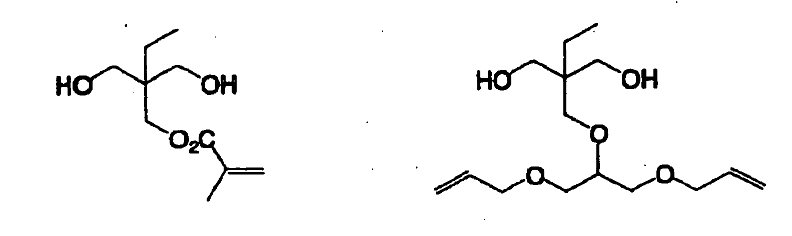

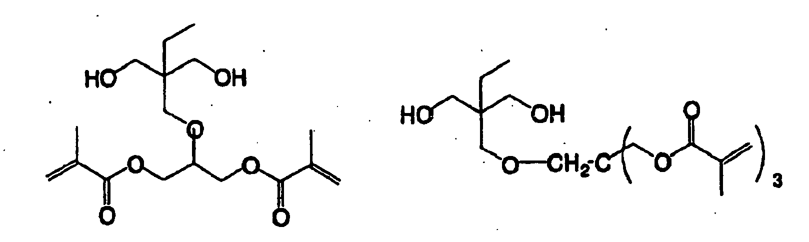

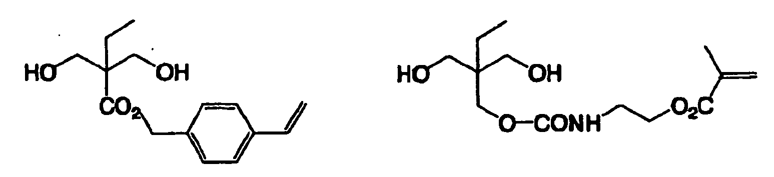

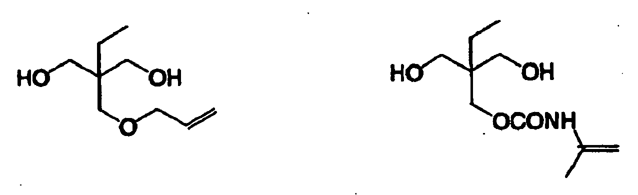

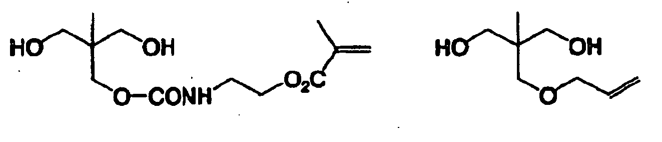

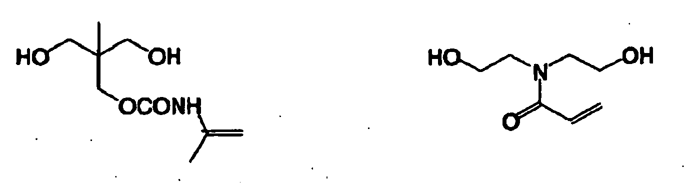

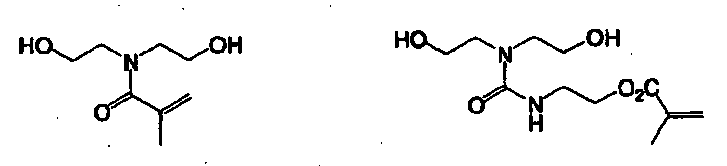

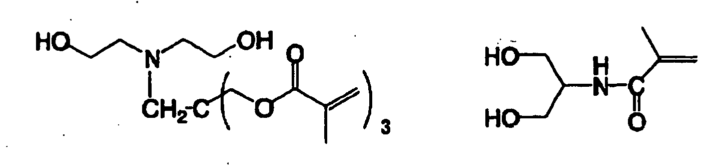

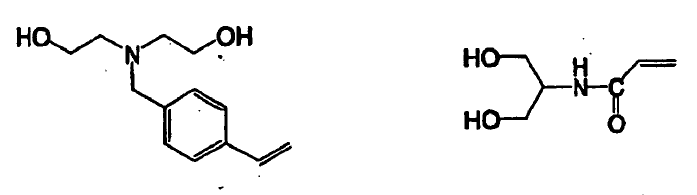

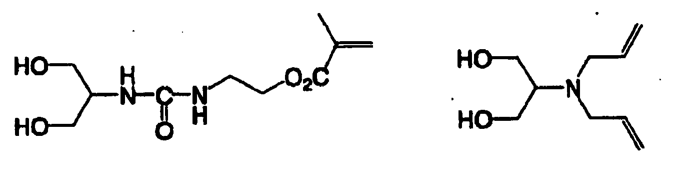

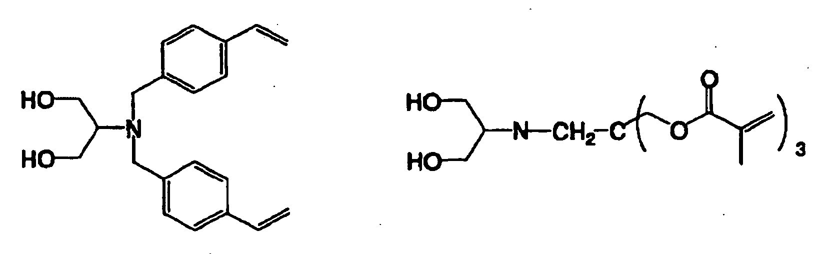

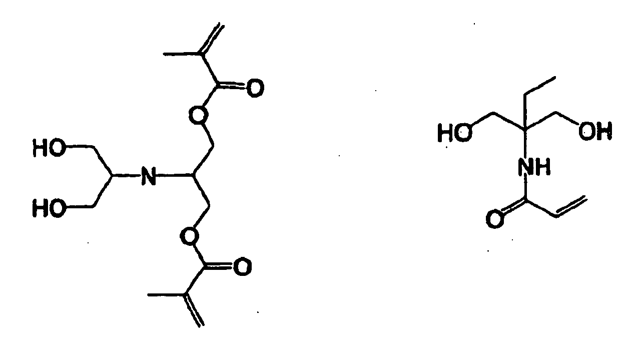

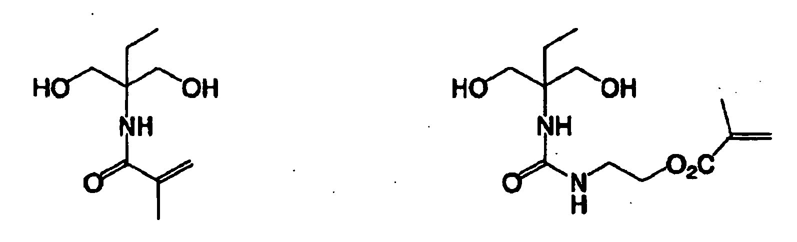

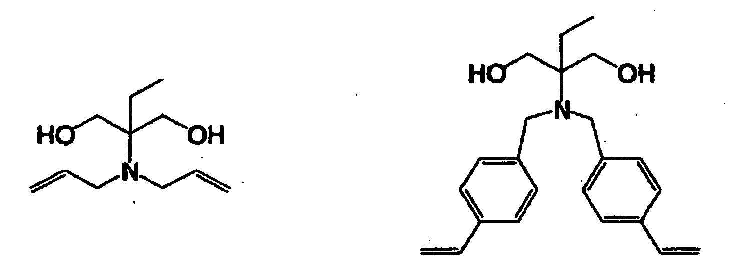

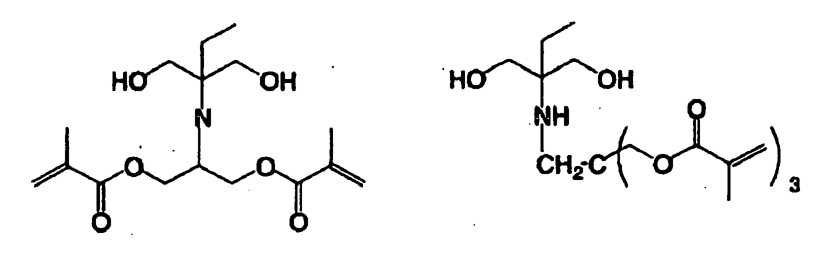

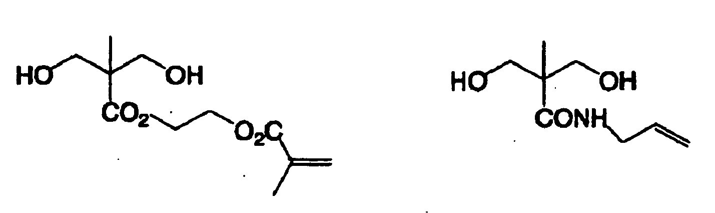

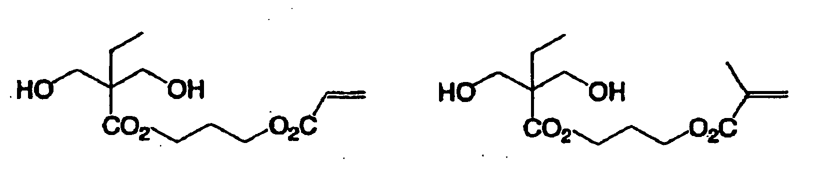

The polymer binder used in the invention not only functions as a film-forming agent but also is needed to be dissolved in a developer, preferably an alkali developer, and thus it is preferable to be soluble or swellable in alkali water. Therefore, it is preferred that the polymer binder according to the invention has an alkali-soluble group, for example, a carboxy group, in the side chain in addition to the crosslinkable group.

Since the diol compound having at least one carboxy group makes it possible to introduce the carboxy group into the side chain of the polyurethane resin by the preparation reaction of urethane polymer with a diisocyanate, it is preferably used for the production of polymer binder according to the invention.

The diol compound having at least one carboxy group includes diol compounds represented by formulae (7), (8) and (9) shown below and/or a compound obtained by ring opening of a tetracarboxylic acid dianhydride with a diol compound. The diol compound used for the purpose of ring opening of the tetracarboxylic acid dianhydride can be used.

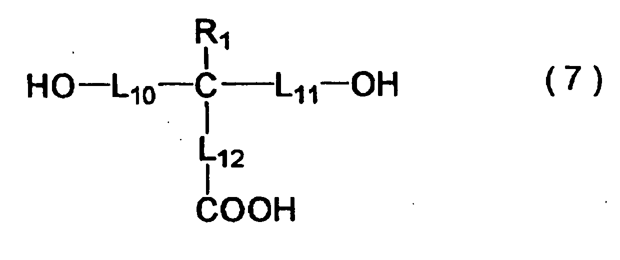

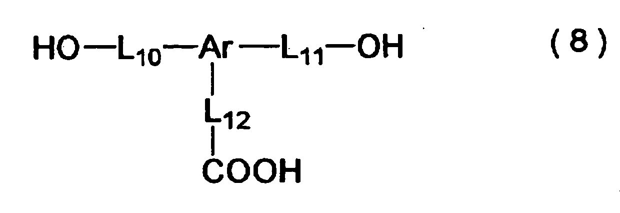

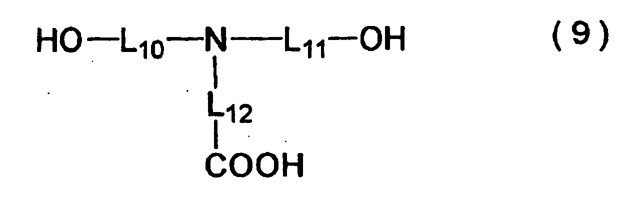

In the formulae, R₁ represents a hydrogen atom, an alkyl group, an aralkyl group, an aryl group, an alkoxy group or an aryloxy group, each of which may have a substituent (for example, a cyano group, a nitro group, a halogen atom (e.g., -F, -Cl, -Br or -I), -CONH₂, -COOR₁₁₃, -OR₁₁₃, -NHCONHR₁₁₃, -NHCOOR₁₁₃, -NHCOR₁₁₃ or -OCONHR₁₁₃ (wherein R₁₁₃ represents an alkyl group having from 1 to 10 carbon atoms or an aralkyl group having from 7 to 15 carbon atoms)); and preferably a hydrogen atom, an alkyl group having from 1 to 8 carbon atoms or an aryl group having from 6 to 15 carbon atoms. L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogeno group); preferably an alkylene group having from 1 to 20 carbon atoms or an arylene group having from 6 to 15 carbon atoms; and more preferably an alkylene group having from 1 to 8 carbon atoms. Also, if desired, L₁₀, L₁₁ and L₁₂ each may contain other functional group which does not react with the isocyanate group, for example, a carbonyl group, an ester group, a urethane group, an amido group, a ureido group or an ether group. Further, two or three of R₁₁, L₁₀, L₁₁ and L₁₂ may be taken together to form a ring. Ar represents a trivalent aromatic hydrocarbon group which may have substituent, and preferably an aromatic group having from 6 to 15 carbon atoms.

Specific examples of the diol compound having a carboxy group represented by formula (7), (8) or (9) include the following compounds.

Specifically, 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl) acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethylglycine and N,N-bis(2-hydroxyethyl)-3-carboxypropionamide are exemplified.

Preferable examples of the tetracarboxylic acid dihydrate, which is used in the preparation of the diol compound having at least one carboxy group, include compounds represented by formula (10), (11) and (12) shown below.

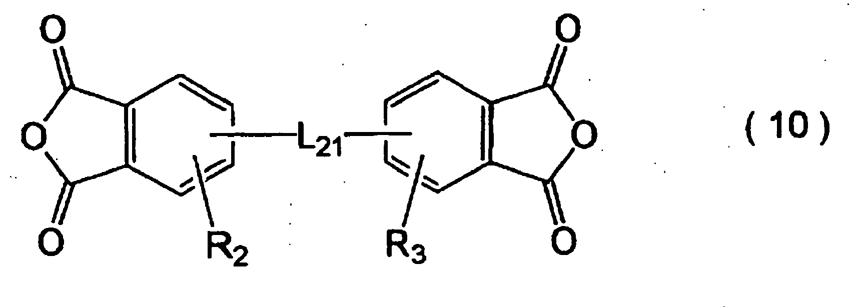

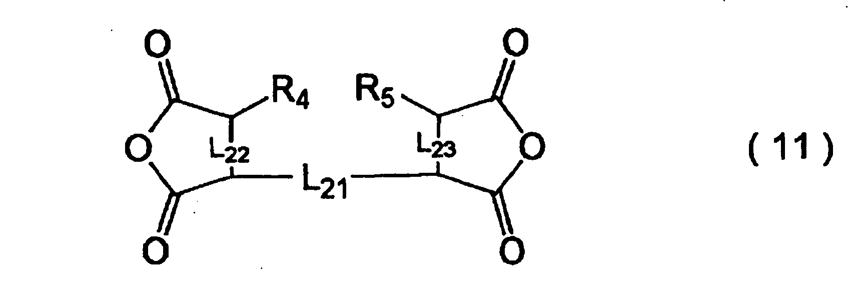

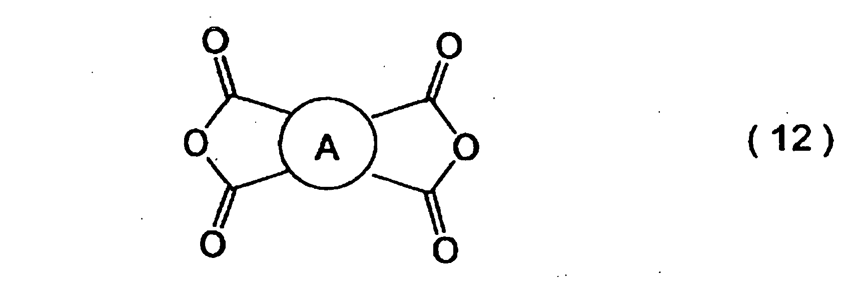

In the formulae, L₂₁ represents a single bond, a divalent aliphatic or aromatic hydrocarbon group which may have a substituent (preferably, for example, an alkyl group, an aralkyl group, an aryl group, an alkoxy group, a halogeno group, an ester group or an amido group), -CO-, -SO-, -SO₂-, -O- or -s-; and preferably a single bond, a divalent aliphatic hydrocarbon group having from 1 to 15 carbon atoms, -CO-, -SO₂-, -O- or -s-. R₂ and R₃, which may be the same or different, each represents a hydrogen atom, an alkyl group, an aralkyl group, an aryl group, an alkoxy group or a halogeno group; and preferably a hydrogen atom, an alkyl group having from 1 to 8 carbon atoms, an aryl group having from 6 to 15 carbon atoms, an alkoxy group having from 1 to 8 carbon atoms or a halogeno group. Alternatively, two of L₂₁, R₂ and R₃ may be combined with each other to form a ring. R₄ and R₅, which may be the same or different, each represents a hydrogen atom, an alkyl group, an aralkyl group, an aryl group or a halogeno group; and preferably a hydrogen atom, an alkyl group having from 1 to 8 carbon atoms or an aryl group having from 6 to 15 carbon atoms. Alternatively, two of L₂₁, R₄ and R₅ may be combined with each other to form a ring. L₂₂ and L₂₃, which may be the same or different, each represents a single bond, a double bond or a divalent aliphatic hydrocarbon group; and preferably a single bond, a double bond or a methylene group. A represents a monocyclic or polycyclic aromatic ring; and preferably an aromatic ring having from 6 to 18 carbon atoms.

Specific examples of the compound represented by formula (10), (11) or (12) include the following compounds.

Specifically, an aromatic tetracarboxylic acid dihydride, for example, pyromellitic acid dihydride, 3,3',4,4'-benzophenonetetracarboxylic acid dihydride, 3,3',4,4'-diphenyltetracarboxylic acid dihydride, 2,3,6,7-naphthalenetetracarboxylic acid dihydride, 1,4,5,8-naphthalenetetracarboxylic acid dihydride, 4,4'-sulfonyldiphthalic acid dihydride, 2,2-bis(3,4-dicarboxyphenyl)propane dihydride, bis(3,4-dicarboxyphenyl)ether dihydride, 4,4'-[3,3'(alkylphosphoryldiphenylene)-bis(iminocarbonyl)] diphthalic acid dihydride, adduct of hydroquinonediacetate and trimellitic acid anhydride or adduct of diacetyldiamine and trimellitic acid anhydride; an alicyclic tetracarboxylic acid dihydride, for example, 5-(2,5-dioxotetrahydrofuryl)-3-methyl-3-cyclohexene-1,2-dicarboxylic acid dihydride (Epicron B-4400, trade name, produced by Dainippon Ink and Chemicals, Inc.), 1,2,3,4-cyclopentanetetracarboxylic acid dihydride, 1,2,4,5-cyclohexanetetracarboxylic acid dihydride or tetrahydrofurantetracarboxylic acid dihydride; and an aliphatic tetracarboxylic acid dihydride, for example, 1,2,3,4-butanetetracarboxylic acid dihydride or 1,2,4,5-pentanetetracarboxylic acid dihydride are exemplified.

By ring-opening of the tetracarboxylic acid dianhydride with a diol compound, a diol compound having at least one carboxy group can be synthesized. It is also possible that a reaction between the diol compound and the diisocyanate compound is initially conducted and the resulting reaction product is reacted with the tetracarboxylic acid dianhydride to synthesize the polyurethane resin according to the invention. This method is also included in the concept of the invention. Specifically, the method of introducing a structural unit resulting from the tetracarboxylic acid dianhydride and the diol compound into the polyurethane resin includes the following methods:
a) Method wherein an alcohol-terminated compound obtained by ring-opening of the tetracarboxylic acid dianhydride with a diol compound is reacted with the diisocyanate compound; and
b) Method wherein an alcohol-terminated urethane compound obtained by reacting the diisocyanate compound under excess of the diol compound is reacted with the tetracarboxylic acid dianhydride.

Of the diol compounds having at least one carboxylic group, the compounds represented by formula (7) are more preferable because of high solvent solubility and ease of synthesis. The diol compound having at least one carboxylic group is introduced into the polyurethane resin binder in an amount so that the polyurethane resin binder contains ordinarily from 0.2 to 4.0 meq/g, preferably from 0.3 to 3.0 meq/g, more preferably from 0.4 to 2.0 meq/g, particularly preferably from 0.5 to 1.5 meq/g, and most preferably from 0.6 to 1.2 meq/g of the carboxy group. Therefore, although the content of the structure derived from the diol compounds having at least one carboxylic group in the polyurethane resin binder can be appropriately determined after considering a number of the carboxy group in the diol compound, other diol compound used in combination, an acid value or molecular weight of the resulting polyurethane resin binder, a composition or pH of developer and the like, it is, for example, ordinarily from 5 to 45% by mole, preferably from 10 to 40% by mole, and more preferably from 15 to 35% by mole.

In order to control the film-forming property, developing property, compatibility with other components of the polyurethane resin, a diol compound other than those described above may be copolymerized.

Other diol compounds include, for example, ethylene glycol compounds represented by the following formula (A'):

HO-(CH₂CH₂O)ₙ-H (A')

In the formula, n represents an integer of 1 or more.

Also, a random copolymer and block copolymer between ethylene oxide and propylene oxide having hydroxy groups at the terminals are exemplified. Further, an ethylene oxide adduct of bisphenol A (addition number of the ethylene oxide is from 27 to 100), an ethylene oxide adduct of bisphenol F (addition number of the ethylene oxide is from 22 to 100), an ethylene oxide adduct of hydrogenated bisphenol A (addition number of the ethylene oxide is from 23 to 100), and an ethylene oxide adduct of hydrogenated bisphenol F (addition number of the ethylene oxide is from 18 to 100) are also used.

More specifically, the ethylene glycol compounds represented by formula (A') are preferable in view of the stain resistance. The ethylene glycol compounds represented by formula (A') wherein n is form 2 to 50 are more preferable, those wherein n is form 3 to 30 are still more preferable, and those wherein n is form 4 to 10 are particularly preferable.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (addition number of the ethylene oxide is 26 or less), an ethylene oxide adduct of bisphenol F (addition number of the ethylene oxide is 21 or less), an ethylene oxide adduct of hydrogenated bisphenol A (addition number of the ethylene oxide is 22 or less), and an ethylene oxide adduct of hydrogenated bisphenol F (addition number of the ethylene oxide is 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethylsulfone, bis(2-hydroxyethyl)-2,4-tolylenedicarbamate, 2,4-tolylene-bis(2-hydroxyethylcarbamide), bis(2-hydroxyethyl)-m-xylylenedicarbamate and bis(2-hydroxyethyl)isophthalate.

Further, polyether diol compounds of compounds represented by formulae (A), (B), (C), (D) and (E) are preferably used.

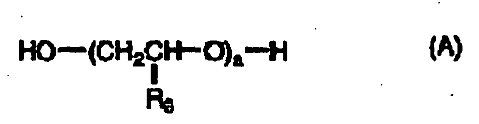

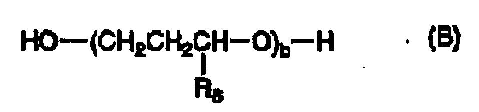

HO-(CH₂CH₂CH₂CH-O)₂-H (C)

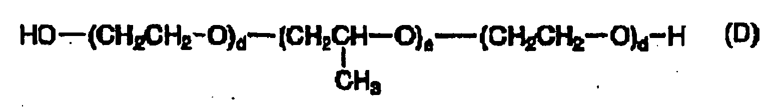

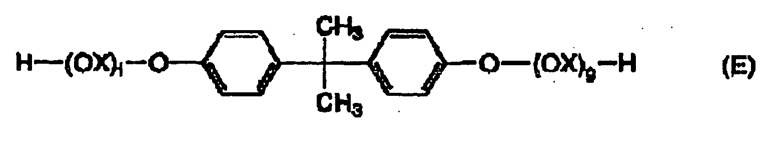

In the formulae, R₆ represents a hydrogen atom or a methyl group, provided that R₆ in formula (A) represents a methyl group.

X represents a group shown below.

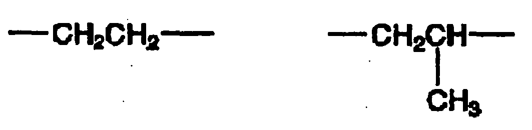

a, b, c, d, e, f and g each represents an integer of 2 or more, and preferably an integer of 2 to 100.

Polyester diol compounds represented by formulae (13) and (14) are also enumerated as specific examples.

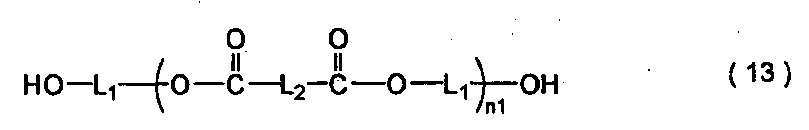

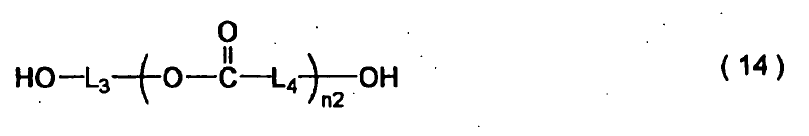

In the formulae, L₁, L₂ and L₃, which may be the same or different, each represents a divalent aliphatic or aromatic hydrocarbon group, and L₄ represents a divalent aliphatic hydrocarbon group. Preferably, L₁, L₂ and L₃ each represents an alkylene group, an alkenylene group, an alkynylene group or an arylene group, and L₄ represents an alkylene group. Also, L₁, L₂, L₃ and L₄ each may have other functional group which does not react with the isocyanate group, for example, an ether group, a carbonyl group, an ester group, a cyano group, an olefin group, a urethane group, an amido group, a ureido group or a halogen atom. n₁ and n₂ each represents an integer of 2 or more, and preferably an integer of 2 to 100.

Polycarbonate diol compounds represented by formula (15) are also enumerated as specific examples.

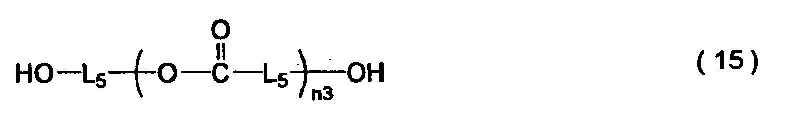

In the formula, L₅, which may be the same or different, each represents a divalent aliphatic or aromatic hydrocarbon group. Preferably, L₅ represents an alkylene group, an alkenylene group, an alkynylene group or an arylene group. Also, L₅ may have other functional group which does not react with the isocyanate group, for example, an ether group, a carbonyl group, an ester group, a cyano group, an olefin group, a urethane group, an amido group, a ureido group or a halogen atom. n₃ represents an integer of 2 or more, and preferably an integer of 2 to 100.

Moreover, diol compounds which does not have a carboxy group and which may have other functional group which does not react with the isocyanate group may be used.

Examples of such diol compound include those shown below.

HO-L₆-O-CO-L₇-CO-O-L₆-OH (16)

HO-L₇-CO-O-L₆-OH (17)

In the formulae, L₆ and L₇, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₆ and L₇ each may have other functional group which does not react with the isocyanate group, for example, a carbonyl group, an ester group, a urethane group, an amid0 group or a ureido group, if desired. Alternatively, L₆ and L₇ may be combined with each other to form a ring.

Specific examples of the diol compound represented by formulae (13) to (17) include those described in JP-A-2003-270775, paragraphs [0049] to [0051] and paragraphs [0055] to [0058].

In addition, compounds described in JP-A-2003-270775, paragraphs [0059] to [0071] are preferably used as the other diol compound.

### 3) Other Amino Group-Containing Compound

In the polyurethane resin binder used in the invention, an amino group-containing compound described below may used together to react with the diisocyanate compound, thereby forming a urea structure to incorporate into the polyurethane resin.

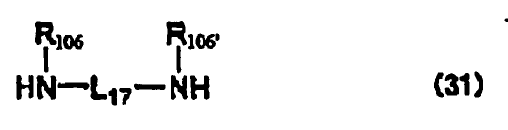

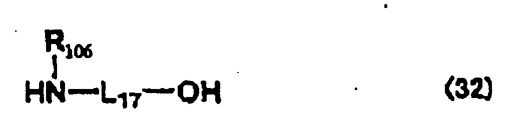

In the formulae, R₁₀₆ and R₁₀₆', which may be the same or different, each represents a hydrogen atom, an alkyl group, an aralkyl group or an aryl group, each of which may have a substituent (for example, an alkoxy group, a halogen atom (e.g., -F, -Cl, -Br or -I), an ester group or a carboxy group); and preferably a hydrogen atom, an alkyl group having from 1 to 8 carbon atoms or an aryl group having from 6 to 15 carbon atoms, each of which may have a carboxy group. L₁₇ represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₁₇ may have other functional group which does not react with the isocyanate group, for example, a carbonyl group, an ester group, a urethane group or an amido group, if desired. Alternatively, two of R₁₀₆, L₁₇ and R₁₀₆' may be combined with each other to form a ring.

Specific examples of the compound represented by formulae (31) and (32) include the following compounds.

Specifically, aliphatic diamine compounds, for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperazine, N,N-dimethylethylenediamine, lysine, L-cystine or isophorondiamine); aromatic diamine compounds, for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, 4,4'-diaminophenyl ether or 1,8-naphthalenediamine; heterocyclic amine compounds, for example, 2-aminoimidazole, 3-aminotriazole, 5-amino-1H-tetrazole, 4-aminopyrazole, 2-aminobenzimidazole, 2-amino-5-carboxytriazole, 2,4-diamono-6-methyl-S-triazine, 2,6-diaminopyridine, L-hystidine, DL-tryptophan or adenine; and aminoalcohol or aminophenol compounds, for example, ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenpl, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol or L-tyrosine are enumerated.

The polyurethane resin used in the invention can be synthesized by heating the diisocyanate compound and the diol compound in an aprotic solvent in the presence of a known catalyst having an activity responding to the reactivity of the compounds. A molar ratio of the diisocyanate (1) to the diol compound (2) or a molar ratio of the diisocyanate (1) to the total compounds other than the diisocyanate compound ((2) + (3)) in the case of using other amino group-containing compound (3) is preferably from 0.8 : 1 to 1.2 : 1. When an isocyanate group is remaining at the polymer terminal, such a compound is treated with an alcohol or an amine so that a compound having no residual isocyanate group can be finally synthesized.

The amount of the other amino group-containing compound (3) is preferably 20% by mole or less based on the total amount of the compounds (2) and (3).

The molecular weight and acid value of the polymer binder used in the invention are appropriately determined in view of the image-forming property and printing durability. Although, the molecular weight and acid value are appropriately controlled depending on pH or composition of a developer, performances required to a printing plate and the like, a molecular weight measured by a GPC method and calculated in terms of polystyrene is preferably in a range from 2,000 to 1,000,000, more preferably from 5,000 to 500,000, and still more preferably from 10,000 to 200,000. With respect to the acid value, the polymer binder having the acid value of 20 to 300 is preferably used.

The polymer binders may be used individually or in combination of two or more thereof in the invention. Also, the polymer binder according to the invention may be used together with one or more other polymer binder having no crosslinkable group. The polymer binder used together is employed ordinarily in a range from 1 to 60% by weight, preferably from 1 to 40% by weight, and more preferably from 1 to 20% by weight, based on the total amount of the polymer binder component. As the polymer binder used together, those conventionally known are employed without any limitation. Specifically, for example, an acryl main chain binder or urethane binder conventionally used in the field of art can be preferably employed.

The total amount of the polymer binder and polymer binder used together in the photosensitive layer can be appropriately determined. It is, however, ordinarily in a range from 10 to 90% by weight, preferably from 20 to 80% by weight, and more preferably from 30 to 70% by weight, based on the total weight of the nonvolatile components in the photosensitive layer.

In view of the image-forming property and developing property, it is preferred that a weight ratio of the compound having a polymerizable ethylenically unsaturated bond and the polymer binder is in a range from 1/9 to 9/1. The weight ratio is preferable from 2/8 to 8/2, and more preferably from 3/7 to 7/3.

### [Polymerization Initiator]

As the polymerization initiator for use in the invention, conventionally known polymerization initiators as described in JP-A-11-38633 can be employed. Preferred examples of the polymerization initiator include (a) an aromatic ketone, (b) an aromatic onium salt compound, (c) an organic peroxide, (d) a ketoxime ester compound, (e) a borate compound, (f) an azinium compound, (g) a metallocene compound, (h) an active ester compound, (i) a compound having a carbon-halogen bond, (j) an azo compound and (k) a hexaarylbiimidazole. Among them, it is preferred to use the hexaarylbiimidazole as the polymerization initiator, because safelight aptitude under yellow light is excellent in connection with spectral sensitivity of the photosensitive layer.

The polymerization initiators (a) to (k) are preferably used individually or in combination of two or more thereof. In such a case, for example, the polymerization initiator other than the hexaarylbiimidazole is preferably used from 1 to 500 parts by weight, more preferably from 25 to 400 parts by weight, and most preferably from 50 to 200 parts by weight, per 100 parts by weight of the hexaarylbiimidazole polymerization initiator.

The hexaarylbiimidazole polymerization initiator for use in the invention includes, for example, lophine dimers described in JP-B-45-37377 and JP-B-44-86516, specifically, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimidazole. The polymerization initiators according to the invention are preferably used individually or in combination of two or more thereof

The amount of the polymerization initiator according to the invention is preferably from 0.01 to 20% by weight, more preferably from 0.1 to 15% by weight, and still more preferably from 1.0 to 10% by weight, based on the total weight of the photosensitive layer.

### [Chain Transfer Agent]

The chain transfer agent for use in the invention preferably includes thiol compounds represented by the following formula (I):

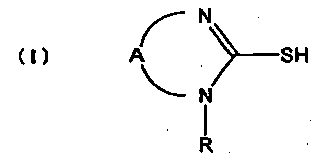

In formula (I), R represents an alkyl group which may have a substituent or an aryl group which may have a substituent; A represents an atomic group necessary for forming a 5-membered or 6-membered hetero ring containing a carbon atom together with the N=C-N linkage, and A may have a substituent.

Compounds represented by formulae (II) and (III) shown below are more preferably used.

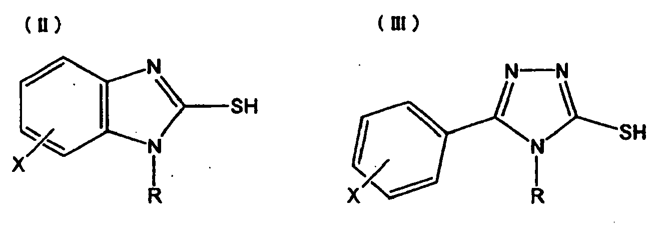

In formulae (II) and (III), R represents an alkyl group which may have a substituent or an aryl group which may have a substituent; and X represents a halogen atom, an alkoxy group, an alkyl group which may have a substituent or an aryl group which may have a substituent.

Specific examples of the compound represented by formula (I) are set forth below, but the invention should not be construed as being limited thereto.

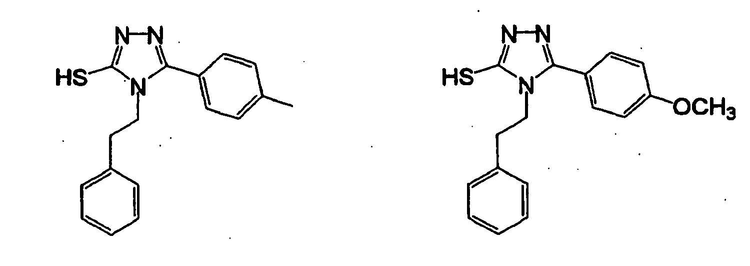

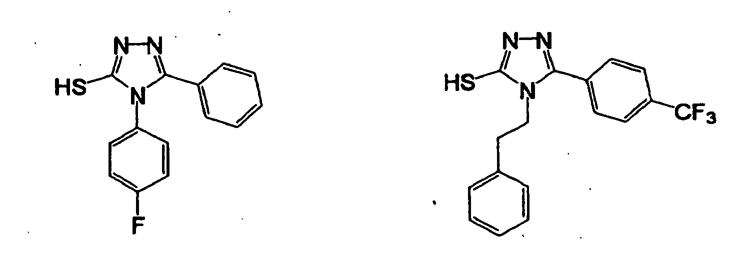

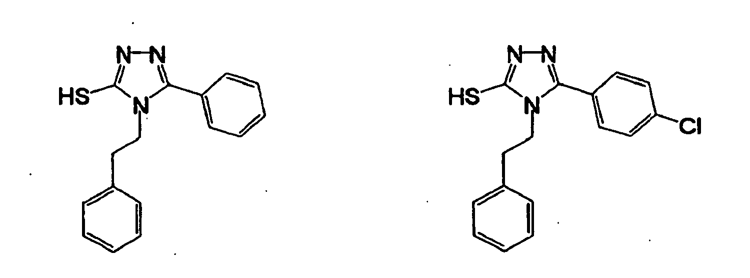

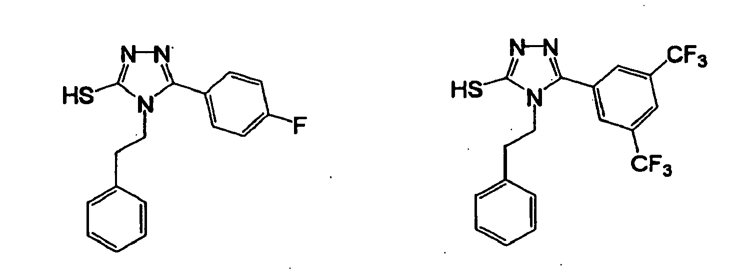

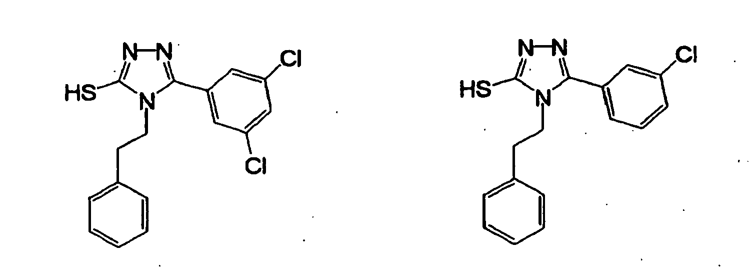

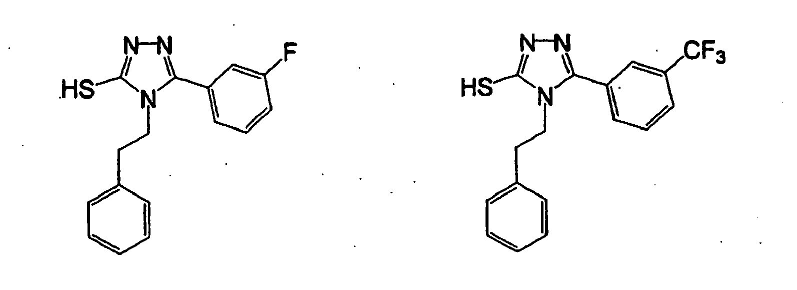

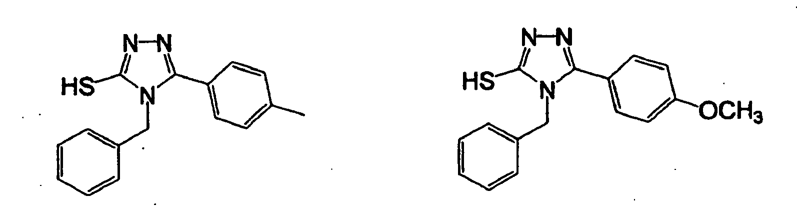

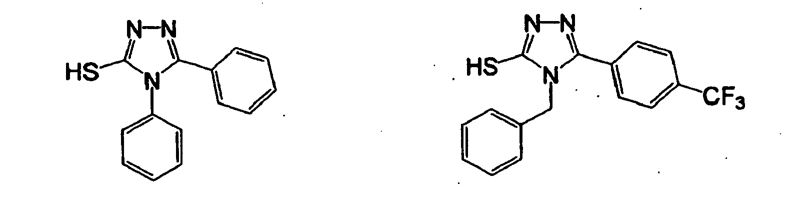

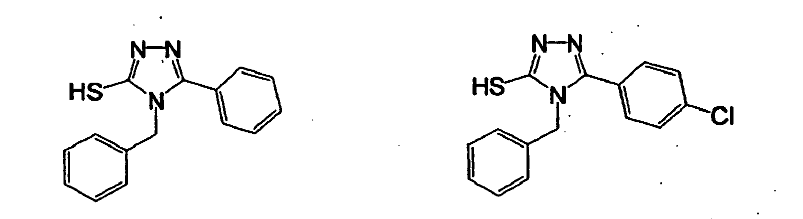

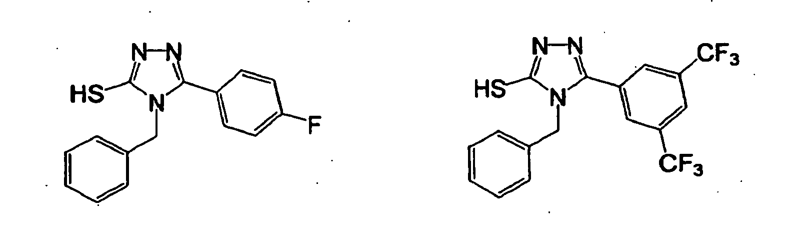

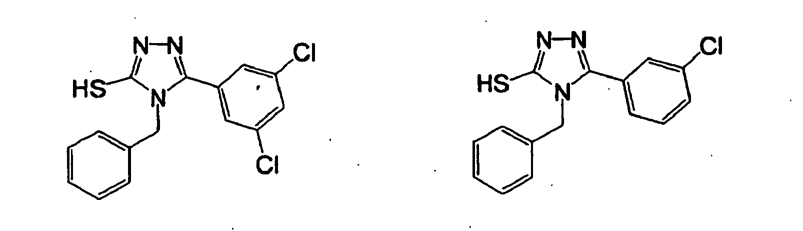

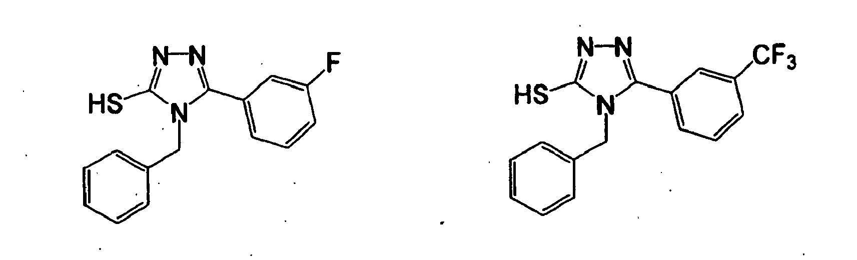

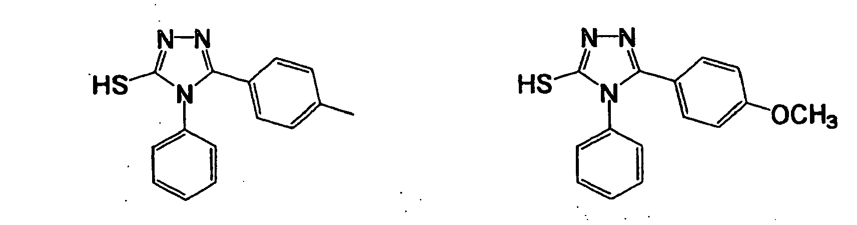

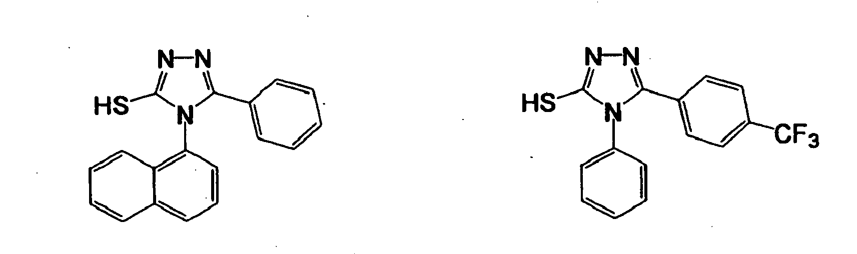

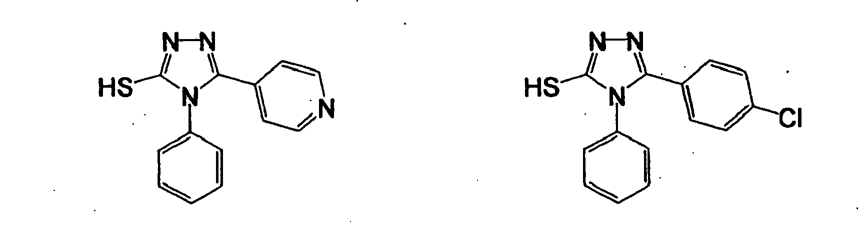

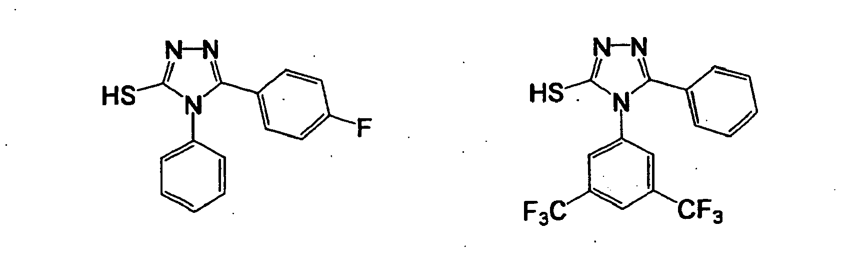

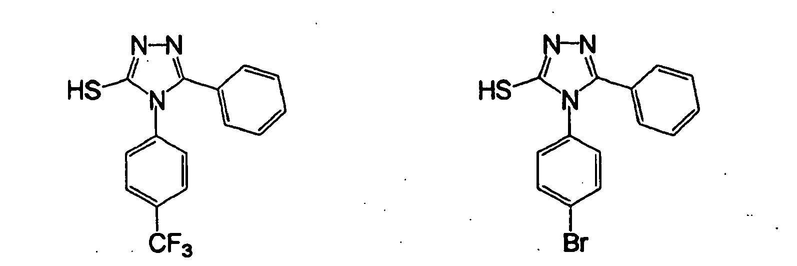

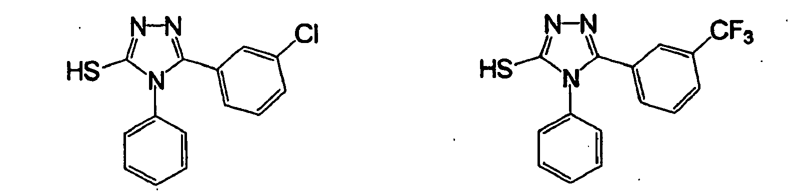

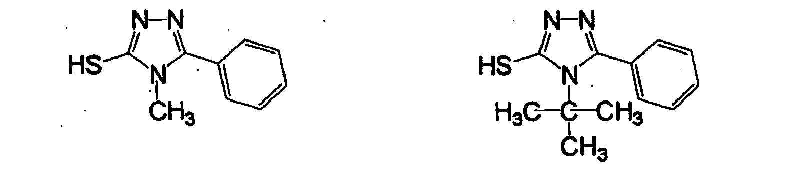

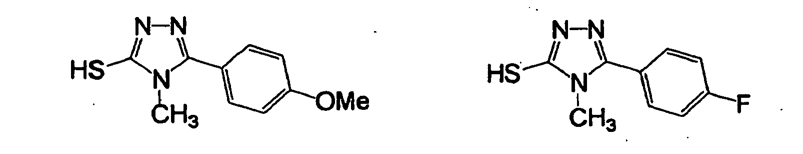

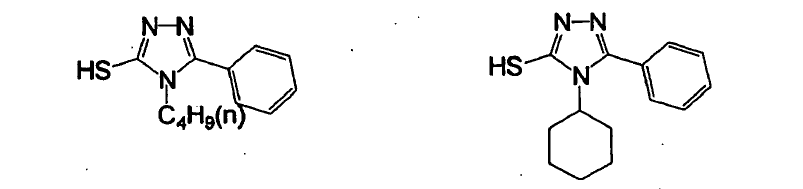

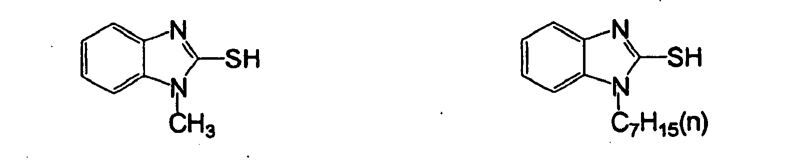

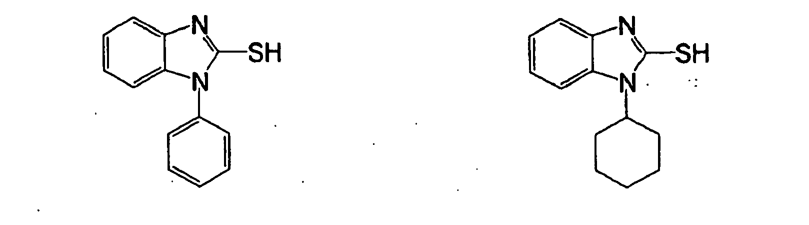

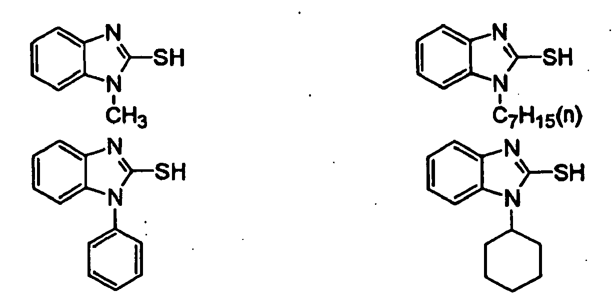

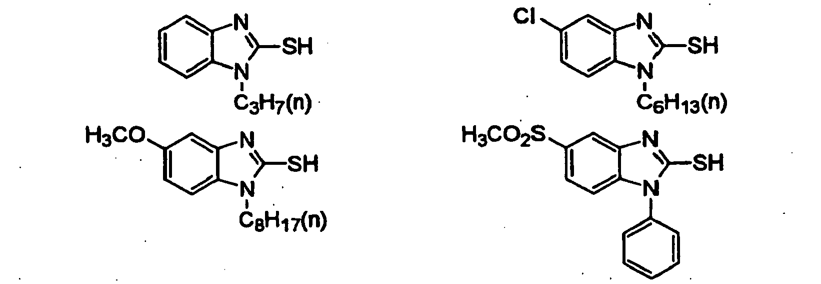

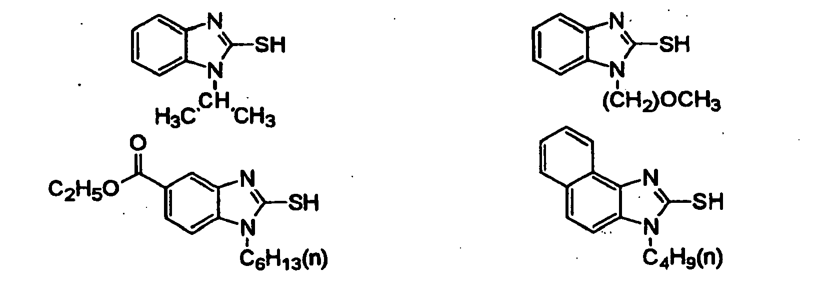

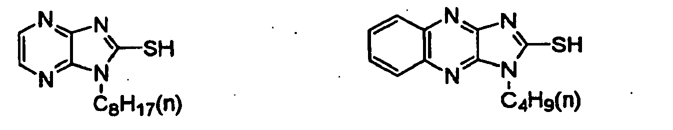

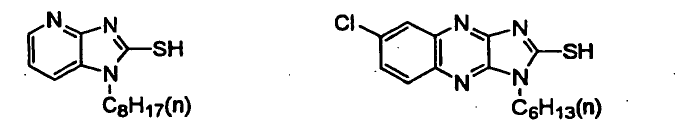

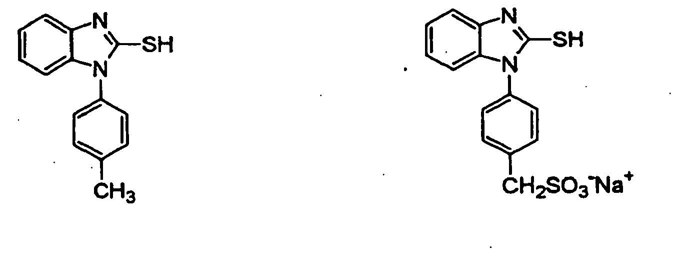

The amount of the thiol compound used is preferably from 0.01 to 20% by weight, more preferably from 0.1 to 15% by weight, and still more preferably from 1.0 to 10% by weight, based on the total solid content of the photosensitive layer.

In the lithographic printing plate precursor according to the invention, sensitivity of the photosensitive layer can be even increased based on effect of preventing polymerization inhibition due to oxygen, when a certain kind of additive (hereinafter referred to as a cosensitizer) is used.

Examples of the cosensitizer include amines, for example, compounds described in M. R. Sander et al, Journal of Polymer Society, Vol., 10, page 3173 (1972), JP-B-44-20189, JP-A-51-82102, JP-A-52-134692, JP-A-59-138205, JP-A-60-84305, JP-A-62-18537, JP-A-64-33104 and Research Disclosure, No. 33825, and specifically, for example, triethanolamine, ethyl p-dimethylaminobenzoate, p-formyldimethylaniline and p-methylthiodimethylaniline.

Other examples of the cosensitizer include amino acid compounds (e.g., N-phenylglycine), organic metal compounds (e.g., tributyl tin acetate) described in JP-B-48-42965, hydrogen donors described in JP-B-55-34414, sulfur compounds (e.g., trithiane) described in JP-A-6-308727, phosphorus compounds (e.g., diethylphosphite) described in JP-A-6-250389, and Si-H and Ge-H compounds.

When the cosensitizer is used, the amount thereof is preferably from 1 to 500 parts by weight, more preferably from 25 to 400 parts by weight, and most preferably form 50 to 200 parts by weight, per 100 parts by weight of the polymerization initiator.

### [Thermal Polymerization Inhibitor]

In the invention, it is preferred to add a small amount of a thermal polymerization inhibitor in addition to the above-described basic components, in order to prevent the compound having a polymerizable ethylenically unsaturated bond from undergoing undesirable thermal polymerization during the production or storage of the photosensitive layer. Suitable examples of the thermal polymerization inhibitor include hydroquinone, p-methoxyphenol, di-tert-butyl-p-cresol, pyrogallol, tert-butylcatechol, benzoquinone, 4,4-thiobis(3-methyl-6-tert-butylphenol), 2,2'-methylenebis(4-methyl-6-tert-butylphenol), N-nitrosophenylhydroxyamine cerium(III) salt and N-nitrosophenylhydroxylamine aluminum salt.

The amount of the thermal polymerization inhibitor added is preferably from about 0.01 to about 5% by weight, based on the total solid content of the photosensitive layer. If desired, in order to prevent polymerization inhibition due to oxygen, a higher fatty acid derivative, for example, behenic acid or behenic amide may be added and allowed to localize on the photosensitive layer surface during the drying step after the coating thereof. The amount of the higher fatty acid derivative added is preferably from about 0.5 to about 10% by weight based on the total solid content of the photosensitive layer.

### [Other Additives]

Further, for the purpose of coloring the photosensitive layer, a coloring agent may be added. Examples of the coloring agent include phthalocyanine pigments (for example, C.I. Pigment Blue 15:3, C.I. Pigment Blue 15:4 or C.I. Pigment Blue 15:6), azo pigments, pigments, for example, carbon black or titanium oxide, Ethyl Violet, Crystal Violet, azo dyes, anthraquinone dyes and cyanine dyes. The amount of the dye or pigment added is preferably from about 0.5 to about 20% by weight of the total composition. In addition, for the purpose of improving physical properties of the cured film, an additive, for example, an inorganic filler or a plasticizer (for example, dioctyl phthalate, dimethyl phthalate or tricresyl phosphate) may be added. The amount of the additive added is preferably 10% by weight or less of the total composition.

### (Support)

In order to obtain a lithographic printing plate precursor, which is one of the main objects of the invention, the above-described photosensitive layer is preferably provided on a support having a hydrophilic surface. As the hydrophilic support, conventionally known hydrophilic supports used for lithographic printing plate precursors can be used without any limitation. The support used is preferably a dimensionally stable plate-like material, for example, paper, paper laminated with plastic (e.g., polyethylene, polypropylene or polystyrene), a metal plate (e.g., aluminum, zinc or copper), a plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal) and paper or a plastic film having laminated with or vapor-deposited thereon the above-described metal. If desired, the surface of the support may be subjected to an appropriate known physical or chemical treatment for the purpose of imparting hydrophilicity, increasing strength or the like.

Preferred examples of the support include paper, a polyester film and an aluminum plate. Among them, the aluminum plate is particularly preferred, because it has good dimensional stability, is relatively inexpensive and can provide a surface having excellent hydrophilicity and strength by a surface treatment as needed. Also, a composite sheet comprising a polyethylene terephthalate film having bonded thereon an aluminum sheet described in JP-B-48-18327 is preferred:

The aluminum substrate is a dimensionally stable metal plate comprising aluminum as a main component, and is selected from a pure aluminum plate, an alloy plate comprising aluminum as a main component and containing trace of foreign elements and a plastic film or paper laminated with or having vapor-deposited thereon aluminum (or alloy thereof).

In the description below, the substrate comprising aluminum or aluminum alloy described above is collectively referred to as an aluminum substrate. Examples of the foreign element contained in the aluminum alloy include silicon, iron, manganese, copper, magnesium, chromium, zinc, bismuth, nickel and titanium. The content of foreign element in the alloy is at most 10% by weight. Although a pure aluminum palate is preferable in the invention, an aluminum plate containing trace of hetero-element may be used, because perfectly pure aluminum is difficult to produce in view of the refining technique.

The composition of the aluminum plate for use in the invention is not limited and aluminum plates comprising conventionally known and used materials, for example, JIS A 1050, JIS A 1100, JIS A 3103 or JIS A 3005 can be appropriately used. The thickness of the aluminum substrate for use in the invention is approximately from 0.1 to 0.6 mm, preferably from 0.15 to 0.4 mm, and particularly preferably from 0.2 to 0.3 mm. The thickness can be appropriately changed depending upon the size of a printing machine, the size of a printing plate and the demands of users. The aluminum substrate may or may not be subjected to a surface treatment for the substrate described hereinafter.

The aluminum substrate is ordinarily subjected to a surface roughening treatment. The surface roughening method includes a method of mechanically roughening the surface, a method of chemical etching and a method of electrolytic graining, as disclosed in JP-A-56-28893. Further, there may be employed an electrochemically surface roughening method of electrochemically roughening the surface in an electrolytic solution of hydrochloric acid or nitric acid and a mechanically surface roughening method, for example, a wire brush graining method of scratching the aluminum surface with a metal wire, a ball graining method of graining the aluminum surface with graining balls and an abrasive and a brush graining method of roughening the surface with a nylon brush and an abrasive. The surface roughening methods may be employed individually or in combination thereof. Of the methods, the electrochemical method of chemically roughening the surface in an electrolytic solution of hydrochloric acid or nitric acid is an advantageous surface roughening method, and an appropriate anodic time electricity is in the range of from 50 to 400 C/dm². More specifically, it is preferred to conduct alternating current and/or direct current electrolysis in an electrolytic solution containing from 0.1 to 50% by weight hydrochloric acid or nitric acid under the conditions from 20 to 80°C in temperature, 1 second to 30 minutes in time and 100 to 400 C/dm² in electric current density.

The thus surface-roughened aluminum substrate may be chemically etched with an acid or an alkali. Etching agents preferably used include, for example, sodium hydroxide, sodium carbonate, sodium aluminate, sodium metasilicate, sodium phosphate, potassium hydroxide and lithium hydroxide. A preferred concentration is in the range of 1 to 50% by weight, and a preferred temperature is in the range of 20 to 100°C. Washing with an acid is conducted for removing stain (smut) remaining on the etched surface. Examples of the acid used include nitric acid, sulfuric acid, chromic acid, hydrofluoric acid and borohydrofluoric acid. As a specific method for desmutting after the electrochemically surface roughening treatment, there are illustrated a method of contacting the aluminum substrate with sulfuric acid from 50 to 90°C in temperature and from 15 to 65% by weight in concentration described in JP-A-53-12739 and a method of etching the substrate with an alkali described in JP-B-48-28123. The method and conditions are not particularly limited as long as the treated surface has a center-line average roughness, Ra, of 0.2 to 0.5 µm.

The thus surface-roughened aluminum substrate is then subjected to an anodizing treatment to form thereon an oxide film. In the anodizing treatment, sulfuric acid, phosphoric acid, oxalic acid and an aqueous solution of boric acid/sodium borate are used individually or in combination of two or more thereof as a major component of an electrolytic bath. In this occasion, ingredients at least ordinarily contained in an aluminum alloy plate, electrodes, city water, ground water and the like may of course be contained in the electrolytic solution. Further, a second or a third component may be added. Examples of the second and third components include a cation, for example, an ion of metal, e.g., Na, K, Mg, Li, Ca, Ti, Al, V, Cr, Mn, Fe, Co, Ni, Cu or Zn or ammonium ion and an anion, for example, nitrate ion, carbonate ion, chloride ion, phosphate ion, fluoride ion, sulfite ion, titanate ion, silicate ion and borate ion. The ion is allowed to be contained in a concentration of approximately from 0 to 10,000 ppm. Although conditions of the anodizing treatment are not particularly limited, the treatment is preferably conducted by direct current or alternating current electrolysis of from 30 to 500 g/liter in concentration, from 10 to 70°C in temperature and from 0.1 to 40 A/m² in electric current density. The thickness of the formed anodic oxide film is in the range of from 0.5 to 1.5 µm, preferably from 0.5 to 1.0 µm.

Further, it is also preferred to undercoat the thus-treated substrate with a water-soluble resin (for example, polyvinylphosphonic acid, a polymer or copolymer having sulfonic acid group in the side chain thereof or polyacryic acid), a water-soluble metal salt (for example, zinc borate), a yellow dye or an amine salt. Still further, a sol-gel treated substrate to which a functional group capable of causing an addition reaction with a radical is connected via a covalent bond as described in JP-A-7-159983 is preferably used.

Other preferred examples include those obtained by providing a water-resistant hydrophilic layer as a surface layer on an appropriate support. Examples of the surface layer include a layer comprising an inorganic pigment and a binder described in U.S. Patent 3,055,295 and JP-A-56-13168, a hydrophilic swellable layer described in JP-A-9-80744, and a sol-gel film comprising titanium oxide, polyvinyl alcohol and a silicic acid described in JP-T-8-507727 (The term "JP-T" as used herein means a published Japanese translation of a PCT patent application). The hydrophilizing treatment is conducted for the purpose of rendering the surface of the support hydrophilic, and for the purpose of preventing harmful reactions of the photosensitive layer provided thereon and improving adhesion to the photosensitive layer.

### [Intermediate layer]

In the lithographic printing plate precursor according to the invention, an intermediate layer may be provided for the purpose of improving adhesion between the photosensitive layer and the substrate and improving stain resistance. Specific examples of the intermediate layer include those described, for example, in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A-7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84674, JP-A-11-38635, JP-A-11-38629, JP-A-10-282645, JP-A-10-301262, JP-A-11-24277, JP-A-11-109641, JP-A-10-319600, JP-A-11-327152, JP-A-2000-10292, JP-A-2000-235254, JP-A-2000-352824 and JP-A-2001-209170.

### [Coating Solution for Photosensitive Layer]

In the coating of the photosensitive layer, each component described above is dissolved in a solvent to prepare a coating solution for the photosensitive layer. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propyolene glycol monoethyl ether acetate, 3-methoxypropyl acetate, N,N-dimethylformamide, dimethylsulfoxide, γ-butyrolactone, methyl lactate and ethyl lactate. The solvents may be used individually or as a mixture thereof.

The concentration of solid content in the coating solution is ordinarily from 1 to 50% by weight.

Further, in order to improve surface quality of coating, a surfactant may be added to the coating solution.

The coating amount of the photosensitive layer is ordinarily from about 0.1 to about 10 g/m², preferably from 0.3 to 5 g/m², and more preferably from 0.5 to 3 g/m², in terms of weight after drying.

### [Plate-Making Method]

Now, a plate-making method of the lithographic printing plate precursor according to the invention will be described in detail. The lithographic printing plate precursor is imagewise exposed and then developed with an aqueous alkali solution. The developer for use in the plate-making method according to the invention is described below.

### (Developer)

The developer for use in the plate-making method according to the invention is not particularly restricted. However, for example, a solution containing an inorganic alkali salt and a nonionic surfactant and having a pH of from 11.0 to 12.7 is preferably used.

The inorganic alkali salt is appropriately used. Examples thereof include an inorganic alkali agent, for example, sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate and ammonium borate. The inorganic alkali salts may be used individually or in combination of two or more thereof.

In the case of using the silicate, developing property can be easily adjusted by selecting a mixing ratio of silicon oxide (SiO₂) to alkali oxide (M₂O (wherein M represents an alkali metal or an ammonium group)), which are the components of the silicate, and the concentration thereof Of the aqueous alkali solutions, an aqueous alkali solution having the mixing ratio of silicon oxide (SiO₂) to alkali oxide (M₂O) (SiO₂/M₂O in molar ratio) of from 0.5 to 3.0 is preferred, and that of from 1.0 to 2.0 is more preferred. The amount of the SiO₂/M₂O added is preferably from 1 to 10% by weight, more preferably from 3 to 8% by weight, most preferably from 4 to 7% by weight, based on the weight of the aqueous alkali solution. When the concentration is in the above-described range, there arise no reduction in the developing property and processing ability, no formation of precipitates and crystals, and no gelation at neutralization of waste liquor of the developer, thereby causing no troubles in treatment of the waste liquor.

Also, an organic alkali agent may be supplementarily used for the purposes of delicate adjustment of alkali concentration and of assisting dissolution of the photosensitive layer. Examples of the organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The organic alkali agents may be used individually or in combination of two or more thereof.

The surfactant is appropriately used. Examples thereof include nonionic surfactants, for example, a nonionic surfactant having polyoxyalkylene ether group, a polyoxyethylene alkyl ester (e.g., polyoxyethylene stearate), a sorbitan alkyl ester (e.g., sorbitan monolaurate, sorbitan monostearate, sorbitan distearate, sorbitan monooleate, sorbitan sesquioleate or sorbitan trioleate) and a monoglyceride alkyl ester (e.g., glycerol monostearate or glycerol monooleate); anionic surfactants, for example, an alkylbenzenesulfonate (e.g., sodium dodecylbenzenesulfonate), an alkylnaphthalenesulfonate (e.g., sodium butylnaphthalenesulfonate, sodium pentylnaphthalenesulfonate, sodium hexylnaphthalenesulfonate or sodium octylnaphthalenesulfonate), an alkylsulfate (e.g., sodium laurylsulfate), an alkylsulfonate (e.g., sodium dodecylsulfonate) and a sulfosuccinic acid ester salt (e.g., sodium dilaurylsulfosuccinate); and amphoteric surfactants, for example, an alkylbetaine (e.g., laurylbetaine or stearylbetaine) and an amino acid. Nonionic surfactants having a polyoxyalkylene ether group are particularly preferred.

As the surfactant having a polyoxyalkylene ether group, compounds having the structure represented by formula (IV) shown below are preferably used.

R₄₀-O-(R₄₁-O)ₚH (IV)

In the formula, R₄₀ represents an alkyl group having from 3 to 15 carbon atoms, an aromatic hydrocarbon group having from 6 to 15 carbon atoms or a heteroaromatic ring group having from 4 to 15 carbon atoms. Each of these groups may have a substituent, and examples of the substituent include an alkylene group having from 1 to 20 carbon atoms, a halogen atom, e.g., Br, Cl or I, an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms and an acyl group having from 2 to 15 carbon atoms. R₄₁ represents an alkylene group having from 1 to 100 carbon atoms, which may have a substituent. Examples of the substituent include an alkyl group having from 1 to 20 carbon atoms and an aromatic hydrocarbon group having from 6 to 15 carbon atoms. p represents an integer from 1 to 100.

In the definition of the formula (IV), specific examples of the "aromatic hydrocarbon group" include a phenyl group, a tolyl group, a naphthyl group, an anthryl group, a biphenyl group and a phenanthryl group, and specific examples of the "heteroaromatic ring group" include a furyl group, a thionyl group, an oxazolyl group, an imidazolyl group, a pyranyl group, a pyridinyl group, an acridinyl group, a benzofuranyl group, a benzothionyl group, a benzopyranyl group, a benzoxazolyl group and a benzimidazolyl group.

Also, the moiety of (R₄₁-O)ₚ in the formula (IV) may comprise two or three kinds of groups within the above-described scope. Specifically, there may be illustrated a random or block chain of a combination of ethyleneoxy group and propyleneoxy group, a combination of ethyleneoxy group and isopropyleneoxy group, a combination of ethyleneoxy group and butyleneoxy group, and a combination of ethyleneoxy group and isobutyleneoxy group. In the invention, the surfactants having polyoxyalkylene ether group are used individually or in combination thereof. The surfactant is effectively added in an amount from 1 to 30% by weight, preferably from 2 to 20% by weight, to the developer. In the above-described range, the developing property is good and printing durability of a printing plate is also good.

Examples of the nonionic surfactant having polyoxyalkylene ether group represented by formula (IV) include a polyoxyethylene alkyl ether, e.g., polyoxyethylene lauryl ether, polyoxyethylene cetyl ether or polyoxyethylene stearyl ether; a polyoxyethylene aryl ether, e.g., polyoxyethylene phenyl ether or polyoxyethylene naphthyl ether; and a polyoxyethylene alkylaryl ether, e.g., polyoxyethylene methylphenyl ether, polyoxyethylene octylphenyl ether or polyoxyethylene nonylphenyl ether.

The surfactants can be used individually or in combination thereof. Also, the amount of the surfactant used in the developer is preferably in the range from 0.1 to 20% by weight in terms of the solid content.

The pH of the developer used in the plate-making method according to the invention is ordinarily from 11.0 to 12.7, preferably from 11.5 to 12.5, in view of the image formation and the damage of the exposed area in the development.

The electric conductivity of the developer used in the invention is preferably from 3 to 30 mS/cm. When it is less than the lower limit, dissolution of the photosensitive layer composition on the aluminum plate support surface becomes difficult, resulting in formation of stain at printing in some cases. On the other hand, when it exceeds the upper limit, due to the high concentration of salt, dissolution rate of the photosensitive layer becomes extremely small, resulting in remaining of the layer in the unexposed area in some cases. The electric conductivity is particularly preferably in the range from 5 to 20 mS/cm.

### (Exposure and Development Processing)

The lithographic printing plate precursor according to the invention is exposed imagewise using a conventionally known active light source, for example, a carbon arc lamp, a high-pressure mercury lamp, a xenon lamp, a metal halide lamp, a fluorescent lamp, a tungsten lamp, a halogen lamp, a helium cadmium laser, an argon ion laser, an FD-YAG laser, a helium neon laser or a semiconductor laser (350 nm to 600 nm), e.g., violet laser. Among them, the violet laser is preferable. After the imagewise exposure, the lithographic printing plate precursor is subjected to the development processing to form an image on the surface of aluminum plate support.

It is possible to provide, between the imagewise exposure and the development processing, a process of heating the photosensitive layer at a temperature of 50 to 140°C for 1 second to 5 minutes for the purpose of increasing the curing ratio of the photosensitive layer. The heating at the temperature in the above-described range serves to increase the curing ratio and prevents the remaining layer in the unexposed area due to dark polymerization.

As described hereinbefore, the protective layer is provided on the photosensitive layer of the lithographic printing plate precursor according to the invention. There are known a method of removing both the protective layer and the unexposed area of the photosensitive layer at the same time by using a developer and a method of first removing the protective layer with water or warm water, and then removing the unexposed area of the photosensitive layer by development. Into the water or warm water may be incorporated an antiseptic described in JP-A-10-10754 or an organic solvent described in JP-A-8-278636.

The development of the lithographic printing plate precursor according to the invention with the above-described developer is conducted in a conventional manner at a temperature of from 0 to 60°C, preferably from about 15 to about 40°C, for example, by immersing the exposed lithographic printing plate precursor in the developer and rubbing with a brush.

Further, in the case of conducting the development processing using an automatic developing machine, the developing solution becomes fatigued in accordance with the processing amount, and hence the processing ability may be restored by using a replenisher or a fresh developer. The thus development-processed lithographic printing plate precursor is after-treated with washing water, a rinse solution containing, for example, a surfactant, or a desensitizing solution containing, for example, gum arabic or a starch derivative as described, for example, in JP-A-54-8002, JP-A-55-115045 and JP-A-59-58431. In the after-treatment of the lithographic printing plate precursor according to the invention, these processings may be used in combination.

The printing plate thus-obtained by the above-described processing may be subjected to the after-exposure treatment described in JP-A-2000-89478 or a heating treatment, for example, baking, in order to improve printing durability.

The lithographic printing plate thus-obtained is mounted on an offset printing machine to print a large number of sheets.

### EXAMPLES

The present invention will be described in more detail with reference to the following examples, but the invention should not be construed as being limited thereto.

### (Preparation method of aluminum support)

A 0.3 mm-thick aluminum plate was etched by dipping in a 10% by weight aqueous sodium hydroxide solution at 60°C for 25 seconds, washed with running water, neutralized and cleaned with a 20% by weight aqueous nitric acid solution and then washed with water. The aluminum plate was then subjected to an electrolytic surface roughening treatment in a 1 % by weight aqueous nitric acid solution using an alternating current with a sinusoidal waveform at an anode time electricity of 300 coulomb/dm². Subsequently, the aluminum plate was dipped in a 1% by weight aqueous sodium hydroxide solution at 40°C for 5 seconds, dipped in a 30% by weight aqueous sulfuric acid solution at 60°C for 40 seconds to effect a desmut treatment, and then subjected to an anodizing treatment in a 20% by weight aqueous sulfuric acid solution for 2 minutes at a current density of 2 A/dm² to form an anodic oxide film having a thickness of 2.7 g/m². The surface roughness was measured and found to be 0.3 µm (Ra value according to JIS B0601).

### (Formation of intermediate Layer)

On the aluminum plate thus-treated was coated a coating solution for intermediate layer shown below using a bar coater, followed by drying at 80°C for 20 seconds. A coating amount of the intermediate layer after drying was 10 mg/m².

**Coating Solution for Intermediate Layer**

| | | |
|---|---|---|
| | Sol solution shown below | 100 g |
| | Methanol | 900 g |

**Sol Solution**

| | | |
|---|---|---|
| | Phosmer PE (trade name, produced by Uni-Chemical Co., Ltd) | 5 g |
| | Methanol | 45 g |
| | Water | 10 g |
| | Phosphoric acid (85% by weight) | 5 g |
| | Tetraethoxysilane | 20 g |
| | 3-Methacryloxypropyltriethoxysilane | 15 g |

### (Formation of photosensitive layer)

Polymerizable composition P-1 of high sensitivity having the composition shown below was coated on the intermediate layer so as to have a dry coating amount of 1.4 g/m² and dried at 100°C for one minute to prepare a photosensitive layer.

**Polymerizable Composition P-1**

| | | |
|---|---|---|
| | Ethylenically unsaturated bond-containing compound (A-1) | 4.2 parts by weight |
| | Polymer binder (B-1) | 3.6 parts by weight |
| | Sensitizing dye (C-1) | 0.21 parts by weight |
| | Polymerization initiator (D-1) | 0.81 parts by weight |
| | Chain transfer agent (compound shown in Table 1 below) | 0.3 parts by weight |
| | ε-Phthalocyanine dispersion | 0.76 parts by weight |
| | Fluorine-containing nonionic surfactant . (Megafac F780, trade name, produced by Dainippon Ink & Chemicals, Inc.) | 0.05 parts by weight |
| | Methyl ethyl ketone | 58 parts by weight |
| | Propylene glycol monomethyl ether acetate | 53 parts by weight |

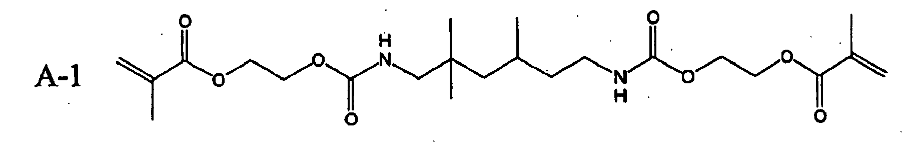

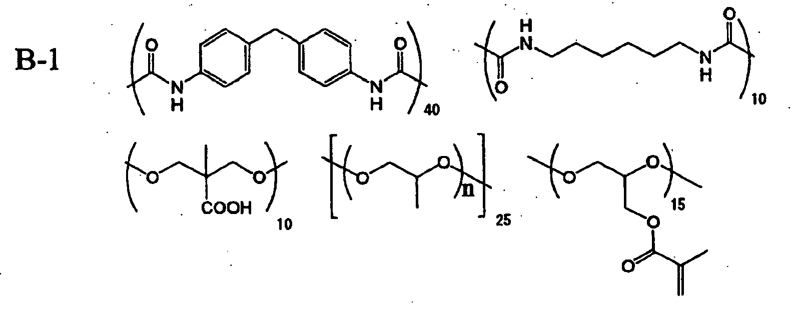

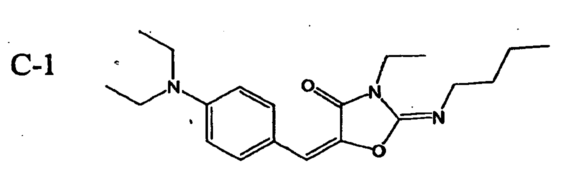

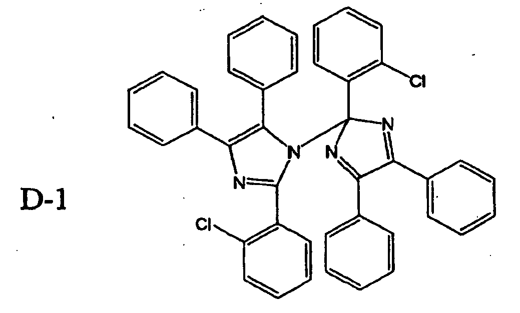

### EXAMPLE 1

A mixed aqueous solution containing a dispersion of stratiform compound prepared as sown below, polyvinyl alcohol (PVA-105, trade name, saponification degree: 98 % by mole, polymerization degree: 500, produced by Kuraray Co., Ltd.), copolymer of vinylpyrrolidone and vinyl acetate (LUVITEC VA64W, trade name, vinylpyrrolidone/vinyl acetate = 6/4, produced by ICP Co., Ltd.) and surfactant (EMALEX 710, trade name, produced by Nihon-Emulsion Co., Ltd.) was coated on the surface of the photosensitive layer by a wire bar and dried in a warm air drying apparatus at 125°C for 75 seconds to form a protective layer, thereby preparing a lithographic printing plate precursor.

The content of the stratiform compound/polyvinyl alcohol/copolymer of vinylpyrrolidone and vinyl acetate/surfactant was 16/80/2/2 % by weight, and the coating amount (coverage after drying) of the protective layer was 1.15 g/m².

### (Preparation of dispersion of stratiform compound)

To 193.6 g of water was added 6.4 g of synthetic mica (Somasif ME-100, trade name, aspect ratio: 1,000 or more, produced by CO-OP Chemical Co., Ltd.) and the mixture was dispersed using a homogenizer until an average particle size (according to a laser scattering method) became 3 µm to obtain a dispersion of mica

### EXAMPLES 2 TO 11 AND COMPARATIVE EXAMPLES 1 AND 3

Lithographic printing plate precursors were prepared in the same manner as in Example 1, except for changing the species and amount of the stratiform compound and the binder PVA-105 used in the protective layer, and the coating amount of the protective layer to those shown in Table 1 below. Also, the content of the copolymer of vinylpyrrolidone and vinyl acetate was so adjusted that the total amount of the stratiform compound and the copolymer of vinylpyrrolidone and vinyl acetate was same as that in Example 1.

### COMPARATIVE EXAMPLE 2

A lithographic printing plate precursor was prepared in the same manner as in Example 1, except for using Polymer binder (B-2) shown below in place of Polymer binder (B-1) in the preparation of the photosensitive layer.

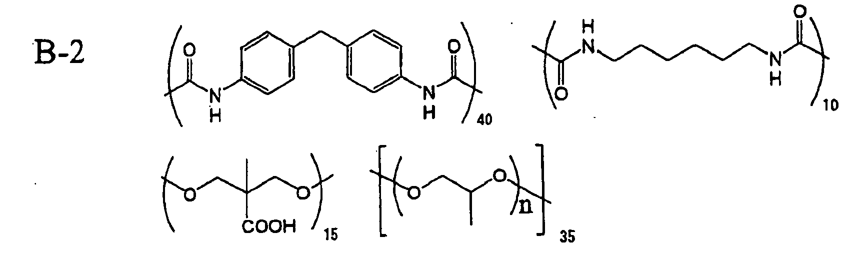

### [Evaluation]

### (1) Evaluation of sensitivity

The lithographic printing plate precursor obtained was subjected to imagewise writing using Vx9600CTP (trade name, wavelength of light source: 405 nm, produced by Fuji Photo Film Co., Ltd.) while controlling an exposure amount on the surface of lithographic printing plate precursor to 0.05 mJ/cm². Then, it was developed using a PS processor (IP850HD, trade name, produced by G & J) fed with an alkali developer having the composition shown below at solution temperature of 25°C for development time of 28 seconds. The cyan density of the image area of the lithographic printing plate obtained by development was measured by a Macbeth reflection densitometer RD-918 through a red filter loaded in the densitometer. A reciprocal of the exposure amount necessary to obtain density of 1.5 measured was taken as the index of sensitivity.

With respect to the result of evaluation, the sensitivity of the lithographic printing plate precursor for Comparative Example 1 was taken as 100, and the sensitivities of other lithographic printing plates were expressed as relative values. The greater the value, the higher the sensitivity is.

**(Composition of alkali developer)**

| | | |
|---|---|---|
| | Potassium hydroxide | 0.15 g |
| | Polyoxyethylene naphthl ether (n=13) | 5.0 g |
| | Chelest 400 (chelating agent) | 0.1 g |
| | Water | 94.75 g |

### (2) Evaluation of printing performance

The lithographic printing plate used for the evaluation of sensitivity in (1) above was subjected to printing using a printing machine (Lithrone, trade name, produced by Komori Corp.) and stain in the non-image area and printing durability were evaluated. The stain in the non-image area was evaluated by sensory evaluation of 1 to 5 levels. Specifically, 5 was the best level, 3 was a level of a lower limit for practical use, and 2 or less was an unacceptable level for practical use.

### (3) Evaluation of adhesion resistance

Three sheets (10 x 10 cm) of the lithographic printing plate precursor were subjected to humidity conditioning under conditions of 25°C and 75% RH for 2 hours. Then, three sheets of the lithographic printing plate precursors were superimposed so that the photosensitive layer side of one lithographic printing plate precursor faced the back layer side of the other lithographic printing plate precursor without using an interleaf between the lithographic printing plate precursors, and hermetically packaged with aluminum craft paper. The hermetically packaged sample was allowed to standing at 30°C for 5 days with loading of 4 kg. Then, state of adhesion between the photosensitive layer side and the back layer side of the sample was evaluated. The adhesion resistance was evaluated by sensory evaluation of 1 to 5 levels. Specifically, 5 was the best level, 3 was a level of a lower limit for practical use, and 2 or less was an unacceptable level for practical use.

### (4) Evaluation of transporting property

Sheets (110 x 40 cm) of the lithographic printing plate precursor were set in Vx9600CTP(trade name, wavelength of light source: 405 nm, produced by Fuji Photo Film Co., Ltd.) without placing an interleaf between the lithographic printing plate precursors and whether the transportation and exposure were normally carried out was confirmed. The evaluation was conducted with continuous processing and an error ratio was determined.

The results of the evaluations are shown in Table 1.

**TABLE 1**

| | Protective Layer | | | | Evaluation Result | | | | |
|---|---|---|---|---|---|---|---|---|---|
| | Stratiform Compound | | Binder | Coating Amount (g/cm²) | Sensitivity | Printing Performance | | Adhesion Resistance | Transporting Property (%) |
| | Species | Weight % | Species | | | Stain | Printing Durability (x 10⁴) | | |
| Comparative Example 1 | - | - | PVA-105 | 2 | 100 | 5 | 8 | 1 | 10 |
| Comparative Example 2 | Somasif ME-100 | 16 | PVA-105 | 1.15 | 60 | 5 . | 3 | 4 | 0 |
| Comparative Example 3 | Somasif ME-100 | 60 | PVA-105 | 1.15 | 50 | 5 | 4 | 4 | 0 |
| Example 1 | Somasif ME-100 | 16 | PVA-105 | 1.15 | 90 | 5 | 7.5 | 3 | 0 |
| Example 2 | Somasif ME-100 | 16 | PVA-105 | 0.5 | 90 | 5 | 7.5 | 4 | 0 |
| Example 3 | Somasif ME-100 | 16 | PVA-105 | 1.5 | 100 | 5 | 8 | 4 | 0 |
| Example 4 | Micromica MK-100*¹ | 10 | PVA-105 | 1.15 | 100 | 5 | 8 | 4 | 0 |
| Example 5 | Micromica MK-100*¹ | 25 | PVA-105 | 1.15 | 100 | 5 | 8 | 5 | 0 |
| Example 6 | Micromica MK-100*¹ | 10 | PVA-105 | 1.5 | 100 | 5 | 8 | 4 | 0 |
| Example 7 | Micromica MK-100*¹ | 20 | PVA-105 | 1.5 | 100 | 5 | 8 | 5 | 0 |
| Example 8 | Micromica MK-100*¹ | 40 | PVA-105 | 1.5 | 95 | 5 | 7.5 | 5 | 0 |
| Example 9 | Somasif ME-100 | 20 | KL-506^{*2} | 0.75 | 95 | 5 | 7.5 | 5 | 0 |
| Example 10 | Somasif ME-100 | 20 | KL-506^{*2} | 1.25 | 100 | 5 | 8 | 5 | 0 |
| Example 11 | Somasif ME-100 | 20 | KL-506^{*2} | 1.75 | 100 | 5 | 8 | 5 | 0 |

| | | | | | | | | | |
|---|---|---|---|---|---|---|---|---|---|
| ^{*1}: Aspect ratio: 20 to 30, trade name, produced by CO-OP Chemical Co., Ltd. ^{*2}: Saponification degree: 77 % by mole, polymerization degree: 600, trade name, produced by Kuraray Co., Ltd. | | | | | | | | | |

As is apparent from the results shown in Table 1, the lithographic printing plate precursors of Examples 1 to 11, that is, lithographic printing plate precursors using the polymer binder according to the invention in the photosensitive layer and containing the stratiform compound in the protective layer, exhibit high sensitivity and good image quality and are excellent in stain resistance in the non-image area and printing durability at printing. Also, it can be seen that adhesion of the lithographic printing plate precursors with each other is prevented under the high humidity condition and that there is no problem in the CTP setter transporting property without using interleaf.

On the contrary, with the lithographic printing plate precursor of Comparative Example 1, which do not contain the stratiform compound in the protective layer, it is found that adhesion of the lithographic printing plate precursors with each other severely occur under the high humidity condition and that there is a practical problem in the CTP setter transporting property without using interleaf.

It is also found that not only the sensitivity, adhesion resistance and transporting property but also the printing durability are achieved by using the polymer binder having a crosslinkable group according to the invention, when the lithographic printing plate precursor of Example 1 is compared with the lithographic printing plate precursor of Comparative Example 2. It is confirmed that film formation is poor to cause decrease in sensitivity and deterioration of printing durability in the lithographic printing plate precursor of Comparative Example 3 containing the excess amount of the stratiform compound in the protective layer.

## Claims

1. A lithographic printing plate precursor comprising:
a hydrophilic support;
a photosensitive layer containing a sensitizing dye having an absorption maximum in a wavelength range of 300 to 500 nm, a polymerization initiator, a chain transfer agent, a compound having an ethylenically unsaturated double bond and a polymer binder having a crosslinkable group in a side chain, and
a protective layer containing an inorganic stratiform compound,
in this order.

2. The lithographic printing plate precursor according to claim 1, wherein a coating amount of the protective layer is from 0.5 g /m² to 2.0 g /m².

3. The lithographic printing plate precursor according to claim 1, wherein a coating amount of the protective layer is from 0.75 g/m² to 1.5 g/m².

4. The lithographic printing plate precursor according to claim 2, wherein a content of the inorganic stratiform compound contained in the protective layer is from 5% by weight to 55% by weight based on the coating amount of the protective layer.

5. The lithographic printing plate precursor according to claim 2, wherein a content of the inorganic stratiform compound contained in the protective layer is from 10% by weight to 40% by weight based on the coating amount of the protective layer.

6. The lithographic printing plate precursor according to claim 1, wherein the inorganic stratiform compound contained in the protective layer has an average major axis of from 0.3 to 20 µm.

7. The lithographic printing plate precursor according to claim 1, wherein the inorganic stratiform compound has a thickness of from 1 to 50 nm.

8. The lithographic printing plate precursor according to claim 1, wherein the inorganic stratiform compound contained in the protective layer is mica.

9. The lithographic printing plate precursor according to claim 1, wherein the polymer binder has an ethylenically unsaturated bonding group.

10. The lithographic printing plate precursor according to claim 1, wherein the chain transfer agent is a thiol compound represented by the following formula (I): 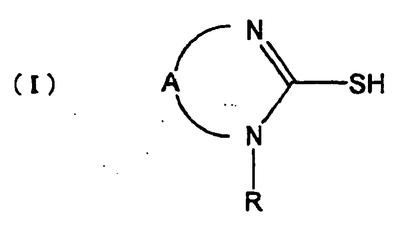 in which R represents an alkyl group which may have a substituent or an aryl group which may have a substituent; A represents an atomic group necessary for forming a 5-membered or 6-membered hetero ring containing a carbon atom together with the N=C-N linkage, and A may have a substituent.

11. The lithographic printing plate precursor according to claim 1, wherein the polymerization initiator is hexaarylbiimidazole.

## Patentansprüche

1. Lithographiedruckplattenvorläufer, umfassend in dieser Reihenfolge:
einen hydrophilen Träger;
eine fotoempfindliche Schicht, die einen Sensibilisierungsfarbstoff mit einem Absorptionsmaximum im Wellenlängenbereich von 300 bis 500 nm, einen Polymerisationsinitiator, ein Kettentransfermittel, eine Verbindung mit einer ethylenisch ungesättigten Doppelbindung und ein Polymer-Bindemittel mit einer vernetzbaren Gruppe in einer Seitenkette umfasst; und
eine Schutzschicht, die eine anorganische Schichtverbindung enthält.

2. Lithographiedruckplattenvorläufer gemäß Anspruch 1, worin die Beschichtungsmenge der Schutzschicht 0,5 g/m² bis 2,0 g/m² beträgt.

3. Lithographiedruckplattenvorläufer gemäß Anspruch 1, worin die Beschichtungsmenge der Schutzschicht 0,75 g/m² bis 1,5 g/m² beträgt.

4. Lithographiedruckplattenvorläufer gemäß Anspruch 2, worin der Gehalt der anorganischen Schichtverbindung, die in der Schutzschicht enthalten ist, von 5 Gew.% bis 55 Gew.% beträgt, bezogen auf die Beschichtungsmenge der Schutzschicht.

5. Lithographiedruckplattenvorläufer gemäß Anspruch 2, worin der Gehalt der anorganischen Schichtverbindung, die in der Schutzschicht enthalten ist, von 10 Gew.% bis 40 Gew.% beträgt, bezogen auf die Beschichtungsmenge der Schutzschicht.

6. Lithographiedruckplattenvorläufer gemäß Anspruch 1, worin die anorganische Schichtverbindung, die in der Schutzschicht enthalten ist, eine mittlere Hauptachse von 0,3 bis 20 µm aufweist.

7. Lithographiedruckplattenvorläufer gemäß Anspruch 1, worin die anorganische Schichtverbindung eine Dicke von 1 bis 50 nm aufweist.

8. Lithographiedruckplattenvorläufer gemäß Anspruch 1, worin die anorganische Schichtverbindung, die in der Schutzschicht enthalten ist, Glimmer ist.

9. Lithographiedruckplattenvorläufer gemäß Anspruch 1, worin das Polymer-Bindemittel eine ethylenisch ungesättigte Bindungsgruppe aufweist.

10. Lithographiedruckplattenvorläufer gemäß Anspruch 1, worin das Kettentransfermittel eine Thiolverbindung ist, die durch die folgende Formel (I) repräsentiert wird: 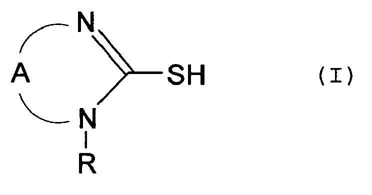 worin R eine Alkylgruppe, die einen Substituenten aufweisen kann, oder eine Arylgruppe, die einen Substituenten aufweisen kann, repräsentiert; A eine atomare Gruppe, die zum Bilden eines 5-gliedrigen oder 6-gliedrigen Heterorings, der ein Kohlenstoffatom enthält, zusammen mit der N=C-N-Verknüpfung notwendig ist, repräsentiert, und A kann einen Substituenten aufweisen.

11. Lithographiedruckplattenvorläufer gemäß Anspruch 1, worin der Polymerisationsinitiator Hexaarylbiimidazol ist.

## Revendications

1. Précurseur de plaque d'impression lithographique comprenant :
un support hydrophile ;
une couche photosensible contenant un colorant sensibilisateur ayant un maximum d'absorption dans une gamme de longueurs d'ondes comprises entre 300 et 500 nm, un initiateur de polymérisation, un agent de transfert de chaîne, un composé ayant une double liaison éthyléniquement insaturée et un liant polymère ayant un groupe dans une chaîne latérale réticulable ; et
une couche protectrice contenant un composé inorganique stratiforme,
dans cet ordre.

2. Précurseur de plaque d'impression lithographique selon la revendication 1, dans lequel une quantité de revêtement de la couche protectrice est comprise entre 0,5 g/m² et 2,0 g/m².

3. Précurseur de plaque d'impression lithographique selon la revendication 1, dans lequel une quantité de revêtement de la couche protectrice est comprise entre 0,75 g/m² et 1,5 g/m².

4. Précurseur de plaque d'impression lithographique selon la revendication 2, dans lequel une teneur en composé inorganique stratiforme contenu dans la couche protectrice est comprise entre 5 % en poids et 55 % en poids sur base de la quantité de revêtement de la couche protectrice.

5. Précurseur de plaque d'impression lithographique selon la revendication 2, dans lequel une teneur en composé inorganique stratiforme contenu dans la couche protectrice est comprise entre 10 % en poids et 40 % en poids sur base de la quantité de revêtement de la couche protectrice.

6. Précurseur de plaque d'impression lithographique selon la revendication 1, dans lequel le composé inorganique stratiforme contenu dans la couche protectrice a un axe principal moyen compris entre 0,3 et 20 µm.

7. Précurseur de plaque d'impression lithographique selon la revendication 1, dans lequel le composé inorganique stratiforme a une épaisseur comprise entre 1 et 50 nm.

8. Précurseur de plaque d'impression lithographique selon la revendication 1, dans lequel le composé inorganique stratiforme contenu dans la couche protectrice est du mica.

9. Précurseur de plaque d'impression lithographique selon la revendication 1, dans lequel le liant polymère a un groupe de liaison éthyléniquement insaturé.

10. Précurseur de plaque d'impression lithographique selon la revendication 1, dans lequel l'agent de transfert de chaîne est un composé thiol représenté par la formule (I) suivante : 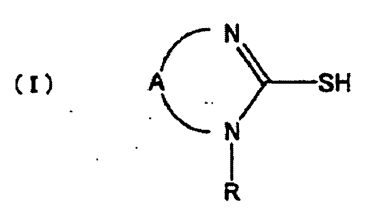 dans laquelle R représente un groupe alkyle qui peut avoir un substituant ou un groupe aryle qui peut avoir un substituant ; A représente un groupe atomique nécessaire pour former un hétérocycle à 5 chaînons ou à 6 chaînons contenant un atome de carbone avec la liaison N=C-N, et A peut avoir un substituant.

11. Précurseur de plaque d'impression lithographique selon la revendication 1, dans lequel l'initiateur de polymérisation est de l'hexaarylbiimidazole.
